# EUROPEAN PATENT APPLICATION

(11) **EP 4 502 858 A1**
(43) Date of publication of application: **05.02.2025**
(21) Application number: 22933518.7
(22) Date of filing: 25.03.2022
(51) Int. Cl.: G06F 30/327, G06F 30/343

(54) **INFORMATION PROCESSING SYSTEM, INFORMATION PROCESSING DEVICE, SERVER DEVICE, PROGRAM, RECONFIGURABLE DEVICE, OR METHOD**

(71) Applicant: Chiptip Technology Kabushiki Kaisha, Tokyo 107-0052 (JP)
(72) Inventor: FUKUDA, Eric Shun, Tokyo 107-0052 (JP)
(74) Representative: Betten & Resch
(86) International application number: PCT/JP2022/014551
(87) International publication number: WO 2023/181380

(57) **Abstract**

PROBLEM

The reconfigurable device can be used more appropriately.

SOLUTION

A system comprising of an acquisition unit to acquire a first resource information that is information about hardware resources that can be used when one or more bit streams related to the first computation node are written to the reconfigurable device; and a second resource information that is information about hardware resources that can be used when one or more bitstreams related to the second computation node are written to the reconfigurable device; and a generation unit to generate synthesized resource information that is information about hardware resources that can be used when one or more bit streams based on the first computation node and the second computation node are written to the reconfigurable device, using the first resource information and the second resource information.

## Description

### Technical Field

The technology disclosed in the present application relates to a system, an information processing device, a server apparatus, a reconfigurable device, a program, a cloud, and/or a method.

### Background Art

In recent years, reconfigurable devices whose circuits can be modified have begun to be introduced in various fields.

### Citation List

### Patent Literature

Patent Literature 1: Japanese patent application laid-open publication No. 2020-135318 A
Patent Literature 2: Japanese patent application laid-open publication No. 2010-251925 A
Patent Literature 3: Japanese patent application laid-open publication No. H7-6080 A

### Summary of Invention

### Technical Problem

However, there is a situation where a technique for more appropriately using a reconfigurable device is not utilized. Various embodiments of the present invention provide an information processing system, an information processing device, a server apparatus, a program, a reconfigurable device, and a method. Solution to Problem

The first embodiment of the present application is:
a system comprising of;
an acquisition unit to acquire
   a first resource information that is information about hardware resources that can be used when one or more bit streams related to the first computation node are written to the reconfigurable device; and
   a second resource information that is information about hardware resources that can be used when one or more bitstreams related to the second computation node are written to the reconfigurable device; and
a generation unit to generate synthesized resource information that is information about hardware resources that can be used when one or more bit streams based on the first computation node and the second computation node are written to the reconfigurable device, using the first resource information and the second resource information.

Other embodiments of the present application is:
a method to operate one or more information processing device comprising with
a step for acquiring
   a first resource information that is information about hardware resources that can be used when one or more bit streams related to the first computation node are written to the reconfigurable device; and
   a second resource information that is information about hardware resources that can be used when one or more bitstreams related to the second computation node are written to the reconfigurable device; and
a step for generating synthesized resource information that is information about hardware resources that can be used when one or more bit streams based on the first computation node and the second computation node are written to the reconfigurable device, using the first resource information and the second resource information.

Other embodiments of the present application is:
a program to operate one or more information processing device comprising with
means for acquiring
   a first resource information that is information about hardware resources that can be used when one or more bit streams related to the first computation node are written to the reconfigurable device; and
   a second resource information that is information about hardware resources that can be used when one or more bitstreams related to the second computation node are written to the reconfigurable device; and
means for generating synthesized resource information that is information about hardware resources that can be used when one or more bit streams based on the first computation node and the second computation node are written to the reconfigurable device, using the first resource information and the second resource information.

### Advantageous Effects of Invention

According to an embodiment of the present invention, a reconfigurable device can be used more appropriately.

### Brief Description of Drawings

FIG. 1 is a block diagram illustrating an example of a relationship between a system and a reconfigurable device according to an embodiment.
FIG. 2 is a block diagram illustrating an example of a relationship between a system and a reconfigurable device according to an embodiment.
FIG. 3 is a diagram illustrating example data used by a system according to an embodiment.
FIG. 4 is a diagram illustrating example data used by a system according to an embodiment.

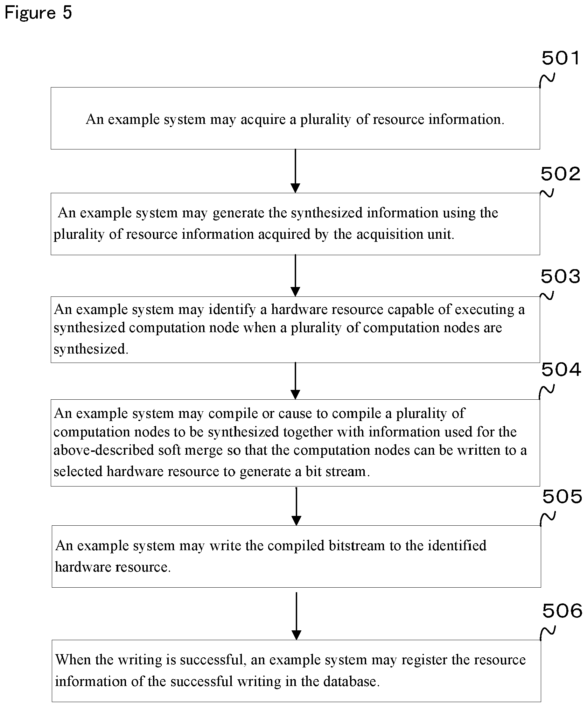

FIG. 5 illustrates an example process by a system according to an embodiment.
FIG. 6 illustrates an example data flow associated with a system according to an embodiment.
FIG. 7 illustrates an example process by a system according to an embodiment.
FIG. 8 illustrates an example process by a system according to an embodiment.
FIG. 9 illustrates an example data flow associated with a system according to an embodiment.
FIG. 10 illustrates an example process by a system according to an embodiment.
FIG. 11 illustrates example data utilized by a system according to an embodiment.
FIG. 12 illustrates a configuration related to a system according to an embodiment.
FIG. 13 illustrates an example process by a system according to an embodiment.
FIG. 14 illustrates example data utilized by a system according to an embodiment.
FIG. 15 illustrates an example data flow associated with a system according to an embodiment.
FIG. 16 illustrates a configuration related to a system according to an embodiment.
FIG. 17 is a block diagram illustrating a configuration of an example of a system according to an embodiment.

### 1. Introduction

An example of the technology disclosed in the present application relates to a rewritable circuit. For example, the technology disclosed in the present application is a technology relating to a rewritable circuit itself, a technology using a non-rewritable circuit for a rewritable circuit, programs used for these circuits, and the like. In an example of the present technology, an information processing device including a non-rewritable circuit may be used. The rewritable circuit is also referred to as a programmable logic device or the like, but in the present application, the rewritable circuit including these is referred to as a reconfigurable device (Reconfigurable Logic Device). On the other hand, a circuit that is not rewritable is sometimes referred to as an instruction decode system, a von Neumann type device, or the like, but in the present application, a circuit including these is referred to as a program variable device.

Examples of the reconfigurable device include a programmable array logic (PAL), a programmable logic array (PLA), a generic array logic (GAL), a complex programmable logic device (CPLD), a field programmable gate array (FPGA), and a coarse-grained reconfigurable array (CGRA).

In the following description of the present application, an FPGA may be used as a reconfigurable device. However, it is needless to say that the present invention can be applied to other reconfigurable devices instead of the FPGA. In particular, as long as the reconfigurable device has a partial reconfiguration function, that is, a function capable of independently writing a plurality of regions (for example, PR regions) in one programmable logic device, the reconfigurable device may be a device capable of performing processing for each region described later. Here, being able to write independently of each other may include a function of being able to write to another region in one programmable logic device different from one region in the one programmable logic device while processing is being executed in the one region in the one programmable logic device.

In the present application, "one" reconfigurable device may exist physically independently. One reconfigurable device may structurally include one or more PR regions. The PR region may be a field in which the circuit configuration can be independently changed. For each PR region, the reconfigurable device may be able to perform one or more independent operations using partial reconfiguration, or may be able to perform one or more independent operations without using partial reconfiguration. Because of the independence, for example, when one reconfigurable device includes the PR region A and the PR region B, the PR region A and the PR region B may operate independently with respect to circuit rewriting and circuit execution. Therefore, the PR region B may be rewritable while the PR region A is being executed. The reconfigurable device may be referred to as a physical device, and the PR region may be referred to as a virtual device.

Data to be written to the reconfigurable device includes a bit stream and a partial bit stream. In the following, as the one including these, it is explained as bit stream.

The bitstream in the present application is acquired by compiling the programs, which may be referred as HDL program, written with the Hardware Descriptive Language, such as VHDL or Verilog.

The HDL programs in the present application may be programmed (coded) by a person, or may be acquireed by converting a program described in a high-level programming language such as C language by a high-level synthesis tool. In the present application, a superordinate concept of a HDL program and a program described in a high-level programming language (any language such as C language or Python language as long as the language is a language to which a high-level synthesis tool can be applied) that can be converted into an HDL program by such a high-level synthesis tool may be referred to as a "target HDL program ".

In the present application, the term "information processing device " is used as a generic term for a reconfigurable device and a programmable device.

An example system may include one or more information processing devices. The one or more information processing devices may include one or more reconfigurable devices and/or one or more programmable devices.

Further, such an example system may be connected to one or more reconfigurable devices. In this case, there is an advantage that the exemplary system can manage one or more reconfigurable devices.

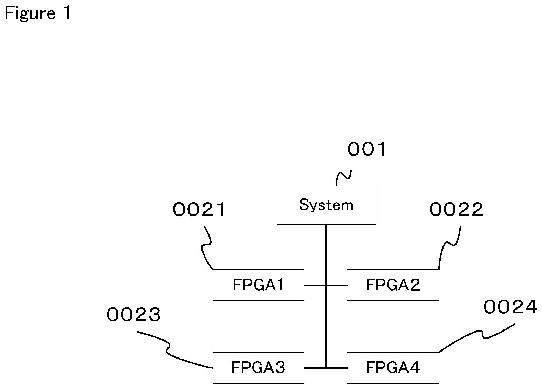

FIG. 1 illustrates an example in which an example system is connected to one or more FPGAs. The system (001) is connected to FPGA1 (0021) to FPGA4 (0024). The connection may be made by Ethernet or a bus such as PCI Express. It should be noted that the example system may be connected only to one or more FPGAs as computing functions for executing user applications. In this case, a hardware resource that executes a function other than the arithmetic function of executing the application of the user may be connected to the program variable device.

A system of an example may be connected to one or more reconfigurable devices, and may be further connected to one or more programmable devices. In this case, a system of an example has an advantage of being able to manage distributed processing including the programmable device in addition to the management of the reconfigurable device.

In the case where an example system is connected to one or more reconfigurable devices and/or one or more programmable devices, the connection may be made directly or indirectly via a network. The one or more reconfigurable devices may be installed in the same facility as the example system or may be installed in a different facility from the example system. The one or more reconfigurable devices may be installed at any specific location. For example, one or more reconfigurable devices may be installed inside a building (indoors) or outside a building (outdoors). IoT equipment such as sensors may operate inside and/or outside a building, and they may be implemented by reconfigurable devices. The network may be wired, wireless, or a combination thereof.

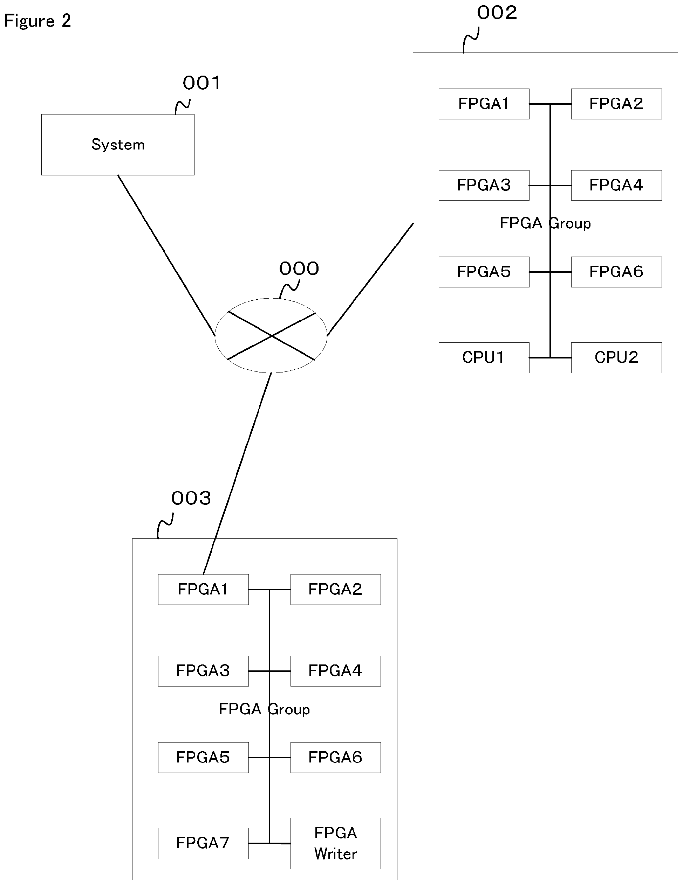

FIG. 2 shows a situation in which an example system is connected to a reconfigurable device and a programmable device via a network (000). This figure shows a configuration example in which the FPGA group (002) includes a plurality of FPGAs and programmable devices. Here, CPU1 and CPU2 are described as the programmable devices, and these are also shown as a part of the FPGA group for convenience. The FPGA group (003) includes a plurality of FPGAs and an information processing device having the functions of an FPGA writer. The FPGA writer may be capable of both writing a bit stream to the FPGA group (003) and writing a bit stream to the FPGA group (002). The network in the FPGA groups (002) and (003) may be a bus, Ethernet, or the like.

Note that the example system, the one or more reconfigurable devices described above, and/or, the one or more programmable devices described above may be information processing devices on a cloud.

In the present application, a computation (or a computation concept) executed in one or more target HDL programs, one or more bitstreams, a PR region, and/or a reconfigurable device is referred to as a computation node, and a unit of a computation node executed in one PR region or one reconfigurable device is referred to as one computation node. One computation node may correspond to one or more target HDL programs. One computation node may correspond to one or more bitstreams. In addition, one computation node can correspond to a unit in which a programmer designates resource information to be described later.

In addition, in the present application document, the hardware resource may indicate a reconfigurable device, a PR region in the reconfigurable device, and/or a programmable device.

### 2, Embodiment 1

The HDL program can be converted into a bit stream by compilation, written to the reconfigurable device, and then subjected to calculation. Generally, a programmer codes an HDL program assuming writing to a specific reconfigurable device (or a PR region of a part thereof).

However, it is assumed that a certain process is realized by a plurality of bit streams (for example, BS1, BS2, and BS3) acquired by compiling a plurality of HDL programs (for example, HDL1, HDL2, and HDL3). When each of the bit streams is written to each of the reconfigurable devices R (for example, RD1, RD2, and RD3), the number of reconfigurable devices to which the bit stream is written becomes plural, and overhead of communication between the plural reconfigurable devices may occur. In view of this, the inventors have considered a technique related to reducing the overhead of communication between reconfigurable devices by making the plurality of written reconfigurable devices into one reconfigurable device (for example, RDX).

In the present application, information processing for converting resource information about hardware resources used by target HDL programs corresponding to N (N is a natural number) computation nodes into resource information about hardware resources used by target HDL programs corresponding to M (M is a natural number smaller than N) computation nodes may be referred to as soft resource merge. In the present application, information processing for converting (compiling) a target HDL program corresponding to a computation node related to soft resource merge into a bit stream may be referred to as soft merge. A plurality of computing nodes to be soft-merged may be regarded as one computing node in some cases. This is because, when a plurality of computation nodes to be soft-merged can generate synthesized information based on resource information corresponding to the plurality of computation nodes by soft resource merge, the computation nodes corresponding to the synthesized information can be regarded as one computation node because the computation nodes can conceive of resource information corresponding to the computation nodes. A process of writing a soft-merged bit stream into a hardware resource may be referred to as a hard merge.

The target HDL program is converted into a bit stream (in the case of a high-level programming language to which a high-level synthesis tool is applied, an HDL program is generated by applying a high-level synthesis tool to a program described in the high-level programming language, and then the HDL program is converted into a bit stream), and the bit stream can be written into the reconfigurable device. Here, the target HDL program may be programmed on the premise of information on the reconfigurable device to be written. For example, a target HDL program has 500 logic blocks, 300 megabytes of memory capacity, and 100 megakilohertz of frequency as the arithmetic processing capacity. When such a target HDL program is written to a reconfigurable device, the capacity and function that the reconfigurable device to which the target HDL program is written needs to have may be referred to as resource information in the present application.

Examples of the resource information include information such as a type of a reconfigurable device, an attribute related to the arithmetic device, an attribute related to the storage device, and/or an attribute related to the communication device. The attribute related to the arithmetic device may include a type of the arithmetic device, the number of arithmetic devices such as the number of cells, a capability of the arithmetic device such as a clock frequency, the number of logic blocks, the number of logic elements (LEs), the number of logic cells (LCs), the number of capacities of a lookup table (LUT), the number of bits of a register, a type of a DSP, a capability of the DSP, the number of DSPs, and/or an amount of power used by the arithmetic device. The attribute related to the storage device may include a type of the storage device, a capacity of the storage device, a read/write speed of the storage device, and/or an amount of power used by the storage device. The storage device may be, for example, an on-chip storage device in the reconfigurable device, but may be another storage device installed outside the reconfigurable device. The attribute related to the communication device may include an attribute related to the internal communication device and/or an attribute related to the external communication device. In addition, the attribute related to the internal communication device may be information of communication related to the inside of the FPGA. The attribute related to the external communication device may include a network bandwidth, the number of communication channels, and/or a band speed of communication with the outside. Note that, in the present application, information of different viewpoints in the resource information (for example, an attribute related to an arithmetic device, an attribute related to a storage device, and/or an attribute related to a communication device, and information of subordinate concepts thereof) may be referred to as an "attribute". Further, the resource information may include one or more pieces of resource information for each attribute. For example, one piece of resource information may include information such as a plurality of frequencies, types of a plurality of storage devices, and the number of a plurality of logic blocks. When there are a plurality of attributes, the corresponding attributes may be included in the resource information in association with each other. In addition to or instead of the case where there are a plurality of attributes, each attribute may be defined by a range. For example, a range such as frequencies X1 to X2 and the number of logic blocks Y1 to Y2 may be defined in one piece of resource information. In particular, when the target HDL program is a program written in a high-level programming language, in the application of the high-level synthesis tool, the type of the reconfigurable device such as the frequency or the number of logic blocks, the attribute related to the arithmetic device, the attribute related to the storage device, and/or the attribute related to the communication device may be automatically determined within a certain range by the selection of the option, so when the resource information includes a rage of information taken by them, soft resource merge or hard marge can be achieved more flexibly.

The resource information for one or more target HDL programs and/or the resource information for one hardware resource may be designated by a programmer. When the programmer programs the target HDL program while considering at least how much computing power and memory power are required, the programmer can designate these pieces of information. Here, the resource information may be designated from a plurality of viewpoints (for example, mandatory, recommended, and the like) for one attribute. For example, it may be identified that the frequency for a certain target HDL program is required to be 1MHZ and recommended to be 2MHZ. Resource information for a certain target HDL program may be automatically generated for the target HDL program. For example, the resource information may be generated by analyzing the target HDL program.

There may be a plurality of PR region setting methods for one reconfigurable device. For example, one reconfigurable device may be divided into two PR regions A and B, or may be divided into four PR regions A to D. In a case where the division methods are different as described above, the resource information for each PR region is also different, and thus the resource information may be stored in association with a specific PR region in a certain division method.

In the present application, "one" resource information may be one unit that a user can use as a hardware resource. Therefore, when the reconfigurable device is not managed with respect to a unit of PR regions, one resource information may be one reconfigurable device. If the reconfigurable device is a hardware resource that is managed with respect to a unit of PR regions and can be used for each PR region, one resource information may be one PR region in one reconfigurable device. Further, one reconfigurable device may be a device that can be purchased independently as a circuit rewritable device.

In the present application, a database that stores resource information in association with a target HDL program may be referred to as an HDL resource database (or HDL-RDB). In the present application, the resource information is not necessarily stored in the form of a database, and the resource information may be stored in association with the target HDL program. One resource information may be stored in association with one or more target HDL programs. One resource information may be stored in association with one computation node.

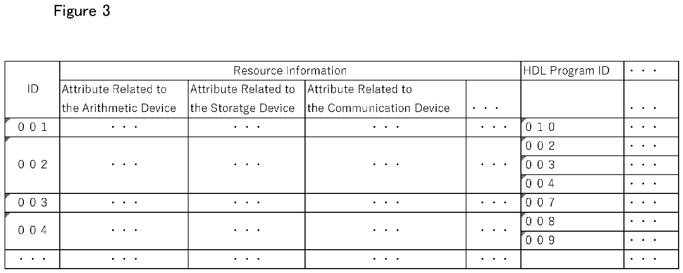

An example of the HDL-RDB is shown in FIG. 3. In this figure, one resource information may be associated with one or more HDL programs. For example, for ID001, one piece of resource information (one set of information for each attribute of the resource information) and one target HDL program are stored in association with each other. When one resource information is associated with a plurality of target HDL programs, a programmer assumes that the programmer compiles the plurality of target HDL programs as target HDL programs for realizing one function and it is written to one hardware resource. For example, for ID002, one resource information and a plurality of target HDL programs 002, 003, and 004 are stored in association with each other. Further, one resource information may be associated with one computation node.

On the other hand, a resource information can also be conceived in the reconfigurable device or the PR region therein. That is, when a reconfigurable device or a PR region in the reconfigurable device is given, the capacity and function of the reconfigurable device or the PR region in the reconfigurable device can be considered. Therefore, a resource information for the reconfigurable device or the PR region in the reconfigurable device can also be considered. In this specification, a database that stores resource information in association with a reconfigurable device or a PR region therein may be referred to as an RFD resource database (or RFD-RDB).

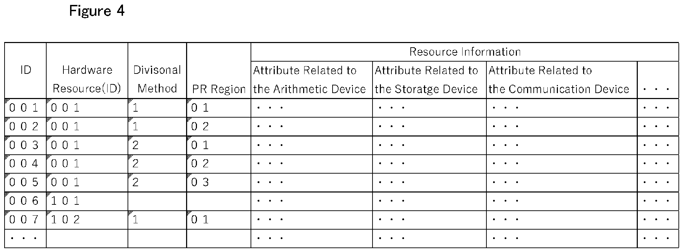

An example of the HDL resource database is shown in FIG. 4. In this figure, each row of the table may indicate one hardware resource capable of writing one or more bitstreams. For example, ID001 and ID002 indicate a case where a hardware resource 001 is divided into a PR region 01 and a PR region 02 (division method 1). Further, ID003 to ID005 show a case where the same hardware resource 001 is divided into PR regions 01 to 03 (division method 2) unlike ID001 and 002. In this way, the physically same hardware resource 001 may be divided into hardware resources having different resource amounts by different division methods (division methods 1 and 2) to realize allocation of hardware resources more suitable (less wasteful) for a computation node to execute, as described later. In addition, ID006 is an example in which the PR region is not set, and is an example in which the hardware resource 101 in which the PR region is not set is directly used as one resource information. In addition, the division of the PR region such as ID001 to ID005 may be stored in the HDL-RDB as information in which the target hardware resource was already divided, or the division of the PR region may be stored in the HDL-RDB as information in a case where the PR region was not actually set in the target hardware resource but as information in a case where it could be divided.

The RFD-RDB and/or HDL-RDB may or may not utilize a database management system. When there is a data model on which the database is based, the data model may be of various types such as a hierarchical type, a network type, a relational data model, and an object data model, and the type thereof is not limited. In addition, a hardware resource that realizes such a database may be a server, a cloud, a dedicated information processing device, and/or a general-purpose information processing device.

When one example system uses the RFD-RDB and/or the HDL-RDB, it is appropriate when the example system may access the RFD-RDB and/or the HDL-RDB, and, the example system may include the RFD-RDB and/or the HDL-RDB, or the example system may not include the RFD-RDB and/or the HDL-RDB. In the latter case, the exemplary system may be directly or indirectly connectable to the RFD-RDB and/or the HDL-RDB via a network or the like.

### Step 1

The resource information acquisition unit may acquire a plurality of resource information.

The resource information acquisition unit may acquire the resource information directly or indirectly. For example, the resource information acquisition unit may acquire a plurality of computing nodes, and acquire resource information corresponding to each of the plurality of computing nodes based on the plurality of computing nodes. Alternatively, the resource information acquisition unit may acquire a plurality of target HDL programs, and acquire corresponding resource information based on the plurality of HDL programs. In these cases, the resource information acquisition unit may alternatively acquire the resource information by using the HDL-RDB. For example, the resource information acquisition unit may acquire the ID and/or the target HDL program corresponding to the computation node and acquire the corresponding resource information using these keys.

In addition, the method of acquisition may be various. For example, the resource information may be acquired from a storage device in an information processing apparatus in which the resource information acquisition unit is implemented, or may be acquired from an information processing device different from the information processing device via a network. The resource information may be acquired based on an input of a user.

### Step 2

The synthesized information generating unit may generate the synthesized information using the plurality of resource information acquired by the acquisition unit. Note that the synthesized information generation unit may be a function for realizing soft resource merge.

The synthesized information may include or be synthesized resource information.

### (Determination Function)

The synthesized information generation unit may have a determination function of determining whether or not the synthesis is possible before generating the synthesis information, or may not have the determination function of determining whether or not the synthesis is possible. In addition, when it is determined that the synthesis is possible, the synthesized information generation unit may determine whether or not the synthesized object operates. For example, the synthesized information generation unit may have a simulation function and may have a function of determining whether or not the synthesized object actually operates. In this case, whether to actually operate as described above may be determined by the simulation function. That is, the simulation may determine whether or not writing to the reconfigurable device is possible. Such a simulation function may be included in the system of the present example or may be outside the system of the present example. In a case where the determination function and/or the simulation function can be executed, the synthesized information generation unit may generate the above-described synthesis information only in a case where it is determined that the synthesis of the resource information is possible and/or the synthesized resource information operates. In a case where the determination function and/or the simulation function can be executed, the synthesized information generation unit may not generate the above-described synthesis information in a case where it is not determined that the synthesis is possible and/or the synthesized object operates.

For example, as described later, when the pipeline cycle, the DSP type, and/or the type of the arithmetic device in the resource information are different in the soft resource merge (for example, when the first resource information and the second resource information are subjected to the soft resource merge, the DSP type and/or the type of the arithmetic device in the first resource information are different from the DSP type and/or the type of the arithmetic device in the second resource information), the synthesized information generation unit may determine that the synthesis is not possible.

Hereinafter, as an example, an example in which the synthesized information generation unit generates one resource information from two pieces of acquired resource information will be described. That is, an example will be described in which the synthesized information generating unit generates the twelfth resource information necessary for writing to the reconfigurable device using the first resource information and the second resource information. The synthesized information generation unit may have a function of generating M pieces of resource information (M is less than N) from N pieces of resource information in addition to a function of generating one piece of resource information from two pieces of resource information described below.

The synthesized information generation unit may have a function of presenting information generated in the soft resource merge to the user. For example, it may have a function of displaying the acquired two resource information and/or the synthesized resource information to the user. In this case, there is an advantage that the user can understand the resource information before being synthesized and/or the synthesized resource information. In particular, in a case where the function of the computation node after the synthesis is changed as compared with each computation node before the synthesis in the soft resource merge, when information including such a change is displayed, there is an advantage that the user can use the change. For example, there is an advantage that the user can understand in a case where synthesized resource information of a type having a high memory access speed is generated in soft resource merge for different types of storage devices, which will be described later. In addition, for example, in a case where the frequency decreases in soft resource merge of computation nodes having different frequencies, which will be described later, there is an advantage that the user can understand such a change.

### SOFT RESOURCE MERGE OF OPERATION INFORMATION

The synthesized information generation unit may generate the attribute related to the arithmetic device of the resource information by summing the attribute related to the arithmetic device related to the first resource and the attribute related to the arithmetic device related to the second resource corresponding to the attribute related to the arithmetic device related to the first resource.

For example, when the number of logic blocks in the attribute related to the arithmetic device related to the first resource is X1 and the number of logic blocks in the attribute related to the arithmetic device related to the second resource is X2, the number of logic blocks of the attribute related to the arithmetic device in the generated synthesized resource information may be X1+X2.

As another example, for example, when the number of digital signal processors (DSPs) in the attribute related to the computing device related to the first resource is X1, and the number of DSPs in the attribute related to the computing device related to the second resource is X2, the number of DSPs of the attribute related to the computing device in the generated synthesized resource information may be X1+X2.

As described above, the corresponding attributes in the first resource information and the second resource information may also be summed to generate the corresponding attribute in the synthesized resource information for the capability related to the arithmetic device that is independent at the time of hard merge, such as the number of arithmetic devices such as the number of cells, the number of logic blocks, and/or the number of DSPs, which are the attributes related to the arithmetic device in the resource information.

On the other hand, with respect to the capability related to the arithmetic device for which the identity is required at the time of hard merge, such as the type of DSP and/or the type of arithmetic device, which is the attribute related to the arithmetic device in the resource information, soft merge is possible only when the corresponding attributes in the first resource information and the second resource information are the same, and the same attribute may be generated as the corresponding attribute in the synthesized resource information.

In addition, regarding the capability related to the arithmetic device capable of covering the other with the higher capability at the time of hard merge, such as the number of bits of the register and/or the number of bits representing the number of digits of the DSP, which is the attribute related to the arithmetic device in the resource information, the corresponding attribute in the first resource information and the second resource information may generate a higher numerical value as the corresponding attribute in the synthesized resource information.

On the other hand, with respect to the capability related to the arithmetic device in which stability should be emphasized at a low capability at the time of hard merge, such as a clock frequency, which is the attribute related to the arithmetic device in the resource information, the corresponding attribute in the first resource information and the second resource information may generate a low numerical value as the corresponding attribute in the synthesized resource information. This is because, in particular, in the case of computing nodes having different frequencies, it may not be possible to adjust a computing node having a low frequency to a computing node having a high frequency, but it is possible to adjust a computing node having a high frequency to a computing node having a low frequency. When there are a plurality of frequencies in one computation node, the smallest frequency among the plurality of frequencies may be used.

In addition, instead of the aspect described above, the computation node after the soft merge and/or the hard merge may be operated at a plurality of different frequencies by a method of connecting modules operating at different frequencies by FIFO or the like. In this case, the synthesized resource information may include a plurality of frequencies. Further, the synthesized resource information may include each of a plurality of frequencies and information indicating calculation processing operated at each frequency in association with each other.

### SOFT RESOURCE MERGE OF STORED INFORMATION

The synthesized information generation unit may generate the attribute related to the storage device of the resource information by summing the attribute related to the storage device related to the first resource and the attribute related to the storage device related to the second resource corresponding to the attribute related to the storage device related to the first resource.

For example, the synthesized information generation unit may generate the attribute related to the storage device of the resource information by summing the attribute related to the storage device related to the first resource and the attribute related to the storage device related to the second resource corresponding to the attribute related to the storage device related to the first resource. For example, when the number of internal memories in the attribute related to the storage device related to the first resource is X1 and the number of internal memories in the attribute related to the storage device related to the second resource is X2, the number of internal memories of the attribute related to the storage device in the generated synthesized resource information may be X1+X2.

As another example, for example, with respect to the external memory in the attribute related to the storage device related to the first resource when the number of shared channels to the external memory is the number EC1 and the number of dedicated channels to the external memory is the number ED1, and with respect to the external memory in the attribute related to the storage device related to the second resource when the number of shared channels to the external memory is the number EC2 and the number of dedicated channels to the external memory is the number ED2, in the attribute related to the storage device in the generated synthesized resource information, the number of shared channels to the external memory may be the larger number (may be 1) of EC1 and EC2, and the number of dedicated channels to the external memory may be ED1+ED2. This is because the shared channel in the external memory can be used even in a case where a delay may occur in access to the storage memory (latency may be slow), and it is possible to cope with a case where there are the number of channels corresponding to the larger number of EC1 or EC2. The number of shared channels to the external memory may be larger than the larger one of EC1 and EC2. For example, a predetermined number of buffers may be additionally provided. In this case, there is an advantage that the number of channels can be provided with a margin corresponding to a predetermined number of buffers. On the other hand, since the dedicated channel is sensitive to latency and is used when delay is not preferable, it is preferable to separately prepare each channel even after soft merge, and the number of channels is set to ED1+ED2.

In addition, regarding the type of the storage device, which is the attribute related to the storage device in the resource information, in a case where the type of the storage device in the first resource information is the type A and the type of the storage device in the second resource information is the type B, when the soft merge process is attempted, any one of the following three processes may be performed. Which of the following three processes is performed may be determined based on user information or may be automatically determined. Further, in any of the user information and the automatic determination, the determination may be made based on preset information, or processing to be dynamically applied may be determined. When the types of storage devices are different, the memory access speeds may be different or the same. When the memory access speed is different, the type of the storage device may be treated as different.
1)The soft merge is performed only when the type A and the type B are the same, and the soft merge is not performed when the type A and the type B are different. When the type A and the type B are the same and soft merge is performed, the type of the corresponding storage device in the synthesized resource information may be the same A (B).
2)The soft merge is performed regardless of whether the type A and the type B are the same or different. When the type A and the type B are the same, the type of the corresponding storage device in the synthesized resource information may be the same A (B). When the type A and the type B are different, the types of the corresponding storage devices in the synthesized resource information may be both the type A and the type B.
3)The soft merge is performed regardless of whether the type A and the type B are the same or different. When the type A and the type B are the same, the type of the corresponding storage device in the synthesized resource information may be the same A (B). When the type A and the type B are different, the type of the corresponding storage device in the synthesized resource information may be a type having a higher memory access speed between the type A and the type B. For example, when the type of the storage device is DDR4, DDR5, HBM2, or the like, the type of the storage device in the synthesized resource information may be HBM2.

### SOFT RESOURCE MERGE OF COMMUNICATION INFORMATION

The synthesized information generation unit may generate the attribute related to the communication device of the synthesized resource information according to a relationship between the first resource and the second resource when soft merge are performed between the attribute related to the communication device related to the first resource and the attribute related to the communication device related to the second resource corresponding to the attribute related to the communication device related to the first resource.

Here, in the present application, a relationship between a first computation node and a second computation node may be referred to as an "output in series relationship " when all outputs of the first computation node are inputs of the second computation node. In this case, some of the inputs of the second computation node may or may not be the outputs of the first computation node.

In addition, in the present application document, a relationship between a first computation node and a second computation node may be referred to as an "input serial relationship " when an output of the first computation node is all inputs of the second computation node. In this case, the output of the first computation node may or may not be the inputs of the second computation node.

In addition, in the present application document, a relationship between a first computation node and a second computation node may be referred to as an "input/output serial relationship " when all outputs of the first computation node are all inputs of the second computation node.

In the present application, the output in series relationship, the input in series relationship, and the input/output in series relationship may be referred to as an "serial relationship " as a superordinate concept. In a case where the first computation node and the second computation node are in a serial relationship, if the first computation node and the second computation node can be hard-merged, there is a connection relationship in input/output information between the first computation node and the second computation node, and thus there is an advantage that overhead related to the input/output can be reduced.

Here, the connection relationship between the first computation node and the second computation node may be a relationship in which an output of the first computation node is directly an input of the second computation node without being subjected to other arithmetic processing.

In addition, in the present application, a case where at least a part of the output of the first computation node is not the input of the second computation node and/or a case where at least a part of the input of the second computation node is not the output of the first computation node may be referred to as a "parallel relationship ".

Note that the presence or absence and/or the form of a connection relationship such as a serial relationship or a parallel relationship between computation nodes may be prepared similarly to the resource information. For example, the presence or absence and/or the mode of the connection relationship may be stored and used as those prepared and created by a programmer at the time of coding, or may be generated and used based on a technique such as data flow analysis between target HDL programs without being created by the programmer at the time of coding.

When the first computation node and the second computation node have an input serial relationship or an input/output serial relationship, the synthesized information generation unit may set the output information of the second resource information as the output information of the synthesis resource information.

For example, it is assumed that the input and the output of the computation node 1 are 10GBPS and 20GBPS, respectively, and the input and the output of the computation node 2 are 20GBPS and 30GBPS, respectively. In this case, the output information of the synthesized resource information may include 30GBPS.

When the first computation node and the second computation node do not have the input serial relationship and do not have the input/output serial relationship, the synthesized information generation unit may set a sum of output information that is not the input information of the second resource information among the output information of the first resource information and the output information of the second resource information as the output information of the synthesis resource information.

For example, it is assumed that the input and output of the computation node 1 are 10GBPS and 20GBPS, respectively, and the input and output of the computation node 2 are 20GBPS and 30GBPS, respectively. The output information of the synthesized resource information may include 40GBPS which is the sum of the output information (10GBPS) which is not the input information of the second resource information among the output information (20GBPS) of the first resource information and the output information (30GBPS) of the second resource information.

When the first computation node and the second computation node have an output serial relationship or an input/output serial relationship, the synthesized information generation unit may set the input information of the first resource information as the input information of the synthesis resource information.

For example, it is assumed that the input and output of the computation node 1 are 10GBPS and 20GBPS, respectively, and the input and output of the computation node 2 are 20GBPS and 30GBPS, respectively. In this case, the input information of the synthesized resource information may include 10BPS.

When the first computation node and the second computation node do not have the output serial relationship and the input/output serial relationship, the synthesized information generation unit may set the sum of the input information of the first resource information and the input information that is not connected to the output information of the first resource information among the input information of the second resource information as the input information of the synthesized resource information.

For example, it is assumed that the input and output of the computation node 1 are 10GBPS and 20GBPS, respectively, and the input and output of the computation node 2 are 20GBPS and 30GBPS, respectively. The input information of the synthesized resource information may include 20GBPS which is the sum of the input information (10GBPS) of the first resource information and the input information (10GBPS) which is not connected to the output information of the first resource information among the input information (20GBPS) of the second resource information.

In the above example, GBPS has been described as an example, but other units may be used. For example, calculation may be performed in other speed units such as BPS, or calculation may be performed in the number of bits corresponding to the frequency in each operation. In particular, when a communication speed (for example, a communication speed in units of GBPS) required or desired in each computation node as described above is designated by a programmer and given as information, the number of communication bits can be calculated from the frequency in each computation node. Therefore, as described above, the number of communication bits corresponding to the changed frequency may be used (for example, since the number of communication bits can be calculated by dividing the communication speed by the frequency) in response to a case where the frequency is changed in soft merge.

The input information and the output information may include communication bit number information and/or a communication speed in the input and the output, respectively.

### Generation of Information Usable for Soft Merge

The synthesized information generation unit may have a function of generating information that can be used for soft merge. For example, the synthesized information generation unit may generate an external memory mapping table and/or an external storage mapping table as the information related to the storage function as the information that can be used for the soft merge. In addition, the synthesized information generation unit may generate, for example, information identifying the number of communication bits and a communication speed as information related to a communication function as information that can be used for soft merge. In addition, the synthesized information generation unit may generate, for example, a module (also referred to as an inter-frequency communication module) having a function such as FIFO for moving data between modules of different frequencies as information related to an operation function as information that can be used for soft merge.

The soft merge is performed by compiling a plurality of target HDL programs. For example, here, an example is considered in which an HDL program 1 of a computation node 1 and an HDL program 2 of a computation node 2 are compiled.

The programmer may create the external memory mapping table 1, the external storage mapping table 1, and the external communication information 1 used by the HDL program 1 for the HDL program 1 of the computation node 1. For the HDL program 2 of the computation node 2, the programmer may create the external memory mapping table 2, the external storage mapping table 2, and the external communication information 2 used by the HDL program 2.

In the above example, the synthesized information generation unit may create a synthesized external memory mapping table from the external memory mapping table 1 and the external memory mapping table 2.

For example, when the external memory mapping table 1 uses 1 to 100 as an address space and the external memory mapping table 2 uses 1 to 100 as an address space, the synthesized external memory mapping table may be generated to use 1 to 200. Here, the table example is an example, and a technique of combining other mapping tables may be used.

Similarly, in the above example, the synthesized information generation unit may create a synthesized external storage mapping table from the external storage mapping table 1 and the external storage mapping table 2.

Similarly, in the above example, the synthesized information generation unit may generate a synthesized communication information module from the external communication information 1 and the external communication information 2. The external communication information 1 may include a communication bit width and frequency information when the HDL program 1 communicates with the outside.

When the first computation node and the second computation node have an output serial relationship, the synthesized information generation unit may generate the external communication module based on the output information of the resource information related to the second computation node.

When the first computation node and the second computation node are not in the output serial relationship, the synthesized information generation unit may generate the external communication module that synthesizes the first output information of the first resource information related to the first computation node and the second output information of the second resource information related to the second computation node.

The synthesized external communication module may be a module that outputs without reducing latency when the first computation node and the second computation node independently communicate with the outside.

For example, the external communication module may include a buffer 1 being capable of storing at least one unit of the packet of the external output of the HDL program 1 and a buffer 2 being capable of storing at least one unit of the packet of the external output of the HDL program 2, having the total number of bits of the number of bits of the external output of the HDL program 1 and the number of bits of the output of the HDL program 2, and may perform an operation of alternately checking the buffers 1 and 2 and outputting the buffer storing at least one unit of the packet to the outside.

Here, for example, when the reconfigurable device communicates with another reconfigurable device or information processing device via Ethernet, one unit of packet may be one unit of packet in Ethernet communication.

The synthesized communication information module, the synthesized external memory mapping table, the synthesized external storage mapping table, and/or the inter-frequency communication module may be used by a compilation function outside the example system. For example, the compile function may use the HDL program 1 associated with the first compute node, the HDL program 2 associated with the second compute node, the synthesized communication information module, the synthesized external memory mapping table, the synthesized external storage mapping table, and/or the inter-frequency communication module to generate a bitstream that implements these.

### Step 3

The identifying unit may identify a hardware resource capable of executing a synthesized computation node when a plurality of computation nodes are synthesized.

The identifying unit may include a determination unit and a selection unit. The identifying process may include a determining process and/or a selecting process. The identifying unit may not include the selecting unit. For example, a hardware resource that is first determined to be executable, which will be described later, may be used.

The determination unit may compare the soft-merged synthesized resource information with the resource information in the RFD-RDB to determine whether the hardware resource corresponding to the resource information in the RFD-RDB can execute the hard-merged computation node corresponding to the soft-merged synthesized resource information.

The determination unit may compare at least one attribute in the soft-merged resource information with a corresponding attribute in the soft-merged resource information in a specific hardware resource in the RFD-RDB, and determine whether the latter can execute the former.

Here, if one attribute is information related to the arithmetic device (or information of a subordinate concept thereof), the corresponding attribute may be information related to the arithmetic device (or information of a corresponding subordinate concept thereof). If one attribute is information related to a storage device (or information of a subordinate concept thereof), the corresponding attribute may be information related to a storage device (or information of a corresponding subordinate concept thereof). If one attribute is information related to a communication device (or information of a subordinate concept thereof), the corresponding attribute may be information related to a communication device (or information of a corresponding subordinate concept thereof).

The determination unit may determine that the hardware resource is executable when a capability of an attribute corresponding to one attribute in the hardware resource is higher than the one attribute in the soft-merged resource information, and may determine that the hardware resource is not executable when the capability is lower than the one attribute in the soft-merged resource information.

More specifically, for example, in a case where one attribute is the number of logic blocks, the determination unit may determine that the processing is executable when the latter is a numerical value higher than the former with respect to the number of logic blocks which is the corresponding attribute.

Similarly, for example, in a case where one attribute is the number of DSPs, the number of bits of a register, or the number of digits of a DSP, the determination unit may determine that each of the number of DSPs, the number of bits of a register, and the number of digits of a DSP, which are the corresponding attributes, is operable when the latter is a numerical value higher than the former.

On the other hand, if the one attribute is the clock frequency, the determination unit may determine that the processing is executable when the latter is a numerical value lower than the former with respect to the clock frequency which is the corresponding attribute.

In addition, for example, in a case where one attribute is the number of internal memories, the number of shared channels to the external memory, or the number of dedicated channels to the external memory, the determination unit may determine that execution is possible when the latter is a numerical value higher than the former with respect to the number of internal memories, the number of shared channels to the external memory, or the number of dedicated channels to the external memory which is the corresponding attribute.

In addition, for example, when the one and the corresponding attribute are the type of the storage device, the determination unit may perform the determination based on predetermined information or dynamically applied processing.

In addition, for example, in a case where one attribute is a communication speed or the number of communication bits, the determination unit may determine that the communication is executable when the latter is a numerical value higher than the former with respect to the communication speed or the number of communication bits which is the corresponding attribute.

In addition, the determination unit may compare all attributes in the soft-resource-merged resource information with each corresponding attribute in the soft-merged resource information in the one specific hardware resource in the RFD-RDB to determine whether the latter can execute the former for all attributes, and may determine that the soft-merged computation node can be executed in the one specific hardware resource in the RFD-RDB when the latter can execute the former for all attributes.

The determination unit may compare at least one attribute in the resource information subjected to the soft resource merge with an attribute corresponding to the one attribute in one specific hardware resource in the RFD-RDB, and determine that the computation node corresponding to the resource information subjected to the soft resource merge cannot be executed by the one specific hardware resource when the latter cannot execute the former. In this case, the determination unit may not compare one or more attributes other than the one attribute in the resource information subjected to the soft resource merge.

### < Determination Unit >

Also, as an example of a specific process, for example, the determination may be performed by the following process.

### Step 311

An example system acquires at least one attribute in the soft merged resource information. Here, the exemplary system may access the HDL-RDB to acquire the one attribute.

### Step 312

The system of an example acquires a corresponding attribute in the soft-merged resource information for a specific hardware resource in the RFD-RDB.

### Step 313

The example system compares the one resource information with the corresponding attribute to determine whether the latter can execute the former.

The example system may compare and determine other attributes in the soft-merged resource information in step 311 described above, as well as attributes in the corresponding hardware resource described above.

An example system may compare and determine all the attributes in the soft-merged resource information in step 311 described above, and similarly, may compare and determine the attributes in the corresponding one hardware resource described above, and may determine that the corresponding one hardware resource is capable of executing the synthesized computation node based on the soft-merged resource information only when it is determined that all the attributes in the soft-merged resource information are capable of executing.

An example system may compare and determine the resource information related to the soft resource merged computation node generated by the other information processing device with the resource information related to the one hardware resource.

### < Selection Unit >

The selection unit may have a function of selecting an efficient hardware resource from among executable hardware resources.

### Step 321

The example system acquires at least one attribute in the soft merged resource information. Here, the example system may access the HDL-RDB to acquire the one attribute.

### Step 322

An example system acquires a corresponding attribute in the soft merged resource information in a specific hardware resource in the RFD-RDB.

### Step 323

An example system generates usage information based on the one resource information and a corresponding attribute.

In the above description, the method is explained in which the process of the determination unit and the process of the selection unit are distinguished and independently processed, but these processes may be collectively processed. For example, in step 313, an example system may execute step 323 and store usage information for the one resource information and the corresponding attribute in association with the one resource information and the corresponding attribute that have been compared.

The usage information may be information indicating a relationship between at least one attribute in the soft resource merged resource information and a corresponding attribute in the soft resource merged resource information in one specific hardware resource in the RFD-RDB, or may include information indicating the relationship.

For example, when the one attribute is the number of logic blocks, the usage information may be information indicating a relationship between the number of logic blocks related to the one attribute and the corresponding number of logic blocks, or may include information indicating the relationship. For example, when the number of logic blocks related to one attribute is 75 and the corresponding number of logic blocks is 100, the usage information may be 3/4, which is a ratio acquired by dividing one attribute by the corresponding attribute, as the ratio of using the hardware resource. The usage information may be a ratio acquired by subtracting a ratio acquired by dividing one attribute by a corresponding attribute from 1, and in this case, may be 1 - 3/4=1/4.

Similarly, when one attribute is the number of DSPs, the number of bits of a register, the number of digits of a DSP, or a clock frequency, the usage information may be information indicating a relationship between these values and the values of the corresponding attributes, or may include information indicating the relationship.

Similarly, when one attribute is the number of internal memories, the number of shared channels to the external memory, or the number of dedicated channels to the external memory, the usage information may be information indicating a relationship between these values and the value of the corresponding attribute, or may include information indicating the relationship.

Further, the usage information may be information indicating a relationship between the soft resource merged resource information and the resource information in one specific hardware resource in the RFD-RDB, or may include information indicating the relationship.

In addition, an example system may generate the usage information by using information indicating each relationship based on each attribute in the soft resource merged resource information and each corresponding attribute in the soft merged resource information in one specific hardware resource in the RFD-RDB. For example, in a case where the soft merged resource information includes the number of logic blocks, the number of DSPs, the number of internal memories, and the number of external memory channels, when the value of each attribute is α for the number of logic blocks, β for the number of DSPs, γ for the number of internal memories, and Δ for the number of external memory channels based on the corresponding resource information in the identified hardware resource, the usage information may be a number generated by a calculation formula off (α, β, γ, Δ) using the function f (that is, arguments α, β, γ, Δ are applied to the function f) or may include the number. The calculation formula may be a weighted calculation formula.

### Step 324

The selection unit may select an efficient hardware resource from among the executable hardware resources based on the usage information.

For example, the selection unit may select one specific hardware resource for usage information having higher efficiency than the others from among a plurality of usage information for one specific hardware resource in each RFD-RDB for the soft resource merged resource information. The highly efficient usage information may be the most efficient usage information. The usage information with high efficiency may be usage information in which the hardware resource can be used higher than the other. For example, the usage information with high efficiency may be usage information in which the ratio of use of the hardware resource in the usage information is higher than other usage information, or usage information in which the value acquired by subtracting the ratio of use of the hardware resource from 1 in the usage information is lower than other usage information. When the use efficiency of the hardware resources is extremely high (for example, 95% or more), the execution time of compilation may be prolonged or compilation may fail. Therefore, the use efficiency may not be extremely high. For example, the use efficiency may be 30% to 95%, 45% to 90%, 60% to 85%, or 70% to 80%, etc. In addition, the use efficiency may be less than 95%, less than 90%, less than 85%, less than 80%, or the like.

Further, for example, with respect to specific soft-merged resource information, in a case where usage information αα for a certain hardware resource α in the RFD-RDB, usage information ββ for a certain hardware resource β in the RFD-RDB, and usage information γγ for a certain hardware resource γ in the RFD-RDB are used, and αα is usage information indicating the highest use efficiency among αα, ββ, and γγ, the selection unit may select the hardware resource α.

An example system may select the hardware resource by using the usage information generated by another information processing device based on the relationship between the soft resource merged resource information related to the computation node and the resource information related to the one hardware resource.

The selection unit may perform the selection based on only the usage information described above, or may perform the selection together with other elements information other than the usage information. The other elements information may be executed automatically or in response to a selection instruction from a user using, for example, information related to the user and/or information related to hardware resources used by the user. In the case of automatic selection, selection may be made according to a preset priority order. When the selection instruction by the user is received, one or a plurality of candidates that can be selected by the user may be displayed to the user, and selection may be performed according to one corresponding to the selection instruction by the user.

In addition, as the information related to the user, information related to a member of the user and/or information related to a membership period of the user may be used.

As an example using the information related to the membership period of the user, for example, an example system may identify the hardware resource using the length of the membership period of the user. For example, in a case where the length of the remaining period of the membership period of the user is equal to or longer than a predetermined period, the example system may perform a process of allocating one of the hardware resources for the long-term use schedule. In this case, there is an advantage that an administrator of the example system can efficiently perform maintenance of the hardware resources. Further, for example, the example system may identify the hardware resource by using the length of the remaining period of the membership period of the user and the scheduled replacement schedule of the hardware. For example, in a case where the length of the remaining period of the membership period of the user is equal to or longer than a predetermined period, the example system may not allocate hardware resources of which the remaining period is equal to or shorter than the predetermined period until the replacement time of the hardware resources. In addition, in a case where the length of the remaining period of the membership period of the user is a first predetermined period, an example system may determine the hardware resource for a hardware resource that is longer than or equal to the first predetermined period until the next replacement time of the hardware resource. In this case, if the membership period of the user is not extended, the maintenance of the hardware resources can be efficiently performed. Note that the information related to the membership period may include a remaining period during which the hardware resource is available, and/or a total or duration from a time when the user joins the membership of the example system.

In addition, the information related to the member of the user may include information related to a course or a position of the member. For example, an example system may allocate one of the predetermined hardware resources when the course of the member of the user is predetermined and/or when the status of the member is predetermined. The predetermined hardware resource may have higher stability and robustness than other hardware resources. In this case, when the user is a specific member or a predetermined course, there is an advantage that a higher-quality hardware resource can be used. The information related to the course or the position of the member may be selected when the user uses the example system. For example, it may be acquired by a contract to the effect that a certain amount of resource information is used.

Further, information related to the hardware resource used by a user may include one or more hardware resources being used by the user at the time of the above-described selection. For example, an example system may include 1) hardware resources in the same FPGA in which the one or more hardware resources that are currently being used by the user; 2) hardware resources in the same local area network or bus as the one or more hardware resources currently being used by the user; and/or 3) those that are at a short distance from the one or more hardware resources currently being used by the user, among real hardware resources that match the resource information selected by the user.

In the case of 1) described above, since the hardware resources are in the same FPGA, there is an advantage that it is possible to support provision of hardware resources that realize more efficient communication by using the hardware resources in the same FPGA as the hardware resources used by the user for the same or related applications.

In the case of 2) described above, since the same local area network or bus of the former is also within the same network or bus, there is an advantage that it is possible to support provision of hardware resources that realize more efficient communication. The identity of the local area network or the bus may be any hierarchy as long as processing for performing communication over the network can be reduced.

The above 2) may be a virtual local network. In this case, although the distance is not necessarily physically shorter than the predetermined distance and the distance related to information communication is not necessarily shorter than the predetermined distance, there is an advantage of high security.

In addition, in the case of 3) described above, the distance may be the physical distance described above or may be a distance related to communication of information. Among the actual hardware resources matching the resource information selected by the user, a hardware resource having a short distance from one or a plurality of hardware resources currently used by the user is selected, so that there is an advantage that it is possible to support provision of a hardware resource that realizes more efficient communication than other hardware resources.

Note that the selection unit may be executed automatically or upon receiving a selection instruction from a user by using the usage information, the information related to the user, and/or the information related to the hardware resources used by the user, which are used as the above-described selection conditions. In the case of automatic selection, selection may be performed using a preset selection criterion. When the selection instruction by the user is received, one or a plurality of candidates that can be selected by the user may be displayed to the user, and selection may be performed according to one corresponding to the selection instruction by the user. When receiving a selection instruction from the user, the system of an example may present, to the user, information about the hardware resource to be selected. For example, information about the hardware resources may be displayed on a display device that is part of the example system or outside the example system connected to the example system. Here, the information on the hardware resource may include resource information on the hardware resource, usage information, information related to the user, and/or information related to the hardware resource used by the user. With these displays, there is an advantage that the user can select the hardware resource while understanding information on the hardware resource to be selected.

### Step 4

An example system may compile or cause to compile a plurality of computation nodes to be synthesized together with information used for the above-described soft merge so that the computation nodes can be written to a selected hardware resource to generate a bit stream.

### Step 5

The example system may write the compiled bitstream to the identified hardware resource.

### Step 6

When the writing is successful, the example system may register the resource information of the successful writing in the database.

The example system may also feed back information about successfully written resource information to the user. Feedback to the user may be performed in various manners. For example, information about successfully written resource information may be displayed on a display device, mailed to the user, or stored in a predetermined location of the user accessible by the user.

An example reconfigurable device may have been identified using soft resource merged synthesized resource information. Such a reconfigurable device has an advantage that processing can be performed with reduced overhead between computation nodes.

An example reconfigurable device may be one in which soft resource merged synthesized resource information is used to write compute nodes. Such a reconfigurable device has an advantage that processing can be performed with reduced overhead between computation nodes.

An example reconfigurable device may be one in which the synthesized resource information acquired by the soft resource merge is used to identify the reconfigurable device, and the synthesized resource information acquired by the soft resource merge is used to write the computation node. Such a reconfigurable device has an advantage that processing can be performed with reduced overhead between computation nodes.

### 3, Embodiment 2

The system of the present example according to the second embodiment is a technique for identifying targets to be soft-merged corresponding to M (M is a natural number smaller than N) computation nodes from N (N is a natural number) computation nodes equal to or larger than 2 or target HDL programs corresponding to the computation nodes. Some or all of the computing nodes to be soft-merged may be automatically determined.

When there are a large number of computation nodes, the user may be confused about which computation node should be synthesized. In particular, if a plurality of (a large number of) computation nodes can be synthesized and written into one hardware resource, there is a possibility that the overhead between the large number of computation nodes can be reduced. On the other hand, if there is no or little input/output relationship between the plurality of (a large number of) computation nodes written into one hardware resource, the overhead may not be effectively reduced. In addition, even when a plurality of (a large number of) computation nodes are to be soft-merged, there may not actually be a hardware resource having a resource sufficient to compile and write the soft-merged target HDL program (for example, when the hardware resource for writing the synthesized computation node exceeds the resource amount of one reconfigurable device). Therefore, the inventors of the present application have focused on the problem of how to select computation nodes to be soft-merged.

Hereinafter, a computation node group including a plurality of computation nodes (here, a set of computation nodes including one or a plurality of computation nodes may be referred to as a computation node group) will be described. An example of a technique for selecting a computation node to be soft-merged will be described.

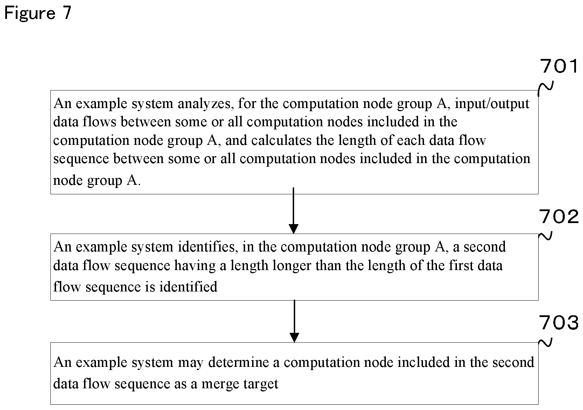

An exemplary processing operation in the exemplary system will be described below with reference to FIG. 7.

### Step 211

For the computation node group A, input/output data flows between some or all computation nodes included in the computation node group A are analyzed, and the length of each data flow sequence between some or all computation nodes included in the computation node group A is calculated (step 701). The length of the data flow sequence may be calculated for some or all of the family of sets of the data flow sequences of the computation node group A. The length of the data flow sequence may be the number of computation nodes included in the data flow sequence. The length of the data flow sequence may be the number of computation nodes of the longest data flow sequence that is not a loop included in the data flow sequence.

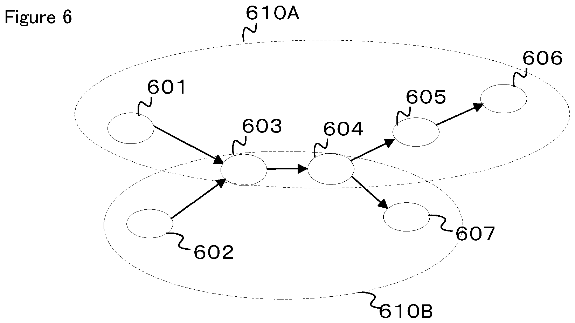

FIG. 6 illustrates a data flow sequence based on computation nodes and input/output paths between the computation nodes. There are computing nodes 601 to 607, and the direction of an arrow between the computing nodes indicates an input/output relationship from one computing node to another computing node. For example, the arrow from compute node 601 to compute node 603 indicates that the output of compute node 601 enters compute node 603. Since the computation node 603 receives arrows from the computation nodes 601 and 602, it is indicated that both the output of the computation node 601 and the output of the computation node 602 are inputs of the computation node 603. Since the arrows from the computation node 604 are directed to the computation nodes 605 and 607, it is indicated that the output of the computation node 604 is the input of the computation node 605 and the input of the computation node 607. In this figure, the number of computing nodes included in a data flow sequence 610A constituted by the computing nodes 601 and 603 to 606 is five, and the number of input/output paths between the computing nodes is four. In addition, the number of computation nodes included in the data flow sequence 610B including the computation nodes 602,603,604, and 607 is four, and the number of input/output paths between the computation nodes is three. The length of the data flow sequence may be the number of computation nodes included in the data flow sequence or the number of input/output paths included in the data flow sequence. In this way, for example, in a case where one data flow sequence includes calculation nodes N1, N2, N3, N4, and N5 in this order, the length of the data flow sequence to be calculated may be a length for a data flow sequence such as N1-N2-N3-N4-N5, N1-N2-N3-N4, N2-N3-N4-N5, N1-N2-N3, N3-N4-N5, and N2-N3-N4. However, the arrangement order of the data flow sequence does not have to have something with a jumping (for example, something with no middle one such as N1-N2-N4-N5 are not the target because the computation node N3 is required between N2 and N4 in terms of computation processing).

### Step 212

In the computation node group A, a second data flow sequence having a length longer than the length of the first data flow sequence is identified (step 701).

For example, in this figure, since the data flow sequence 610A is longer than the data flow sequence 610B, the data flow sequence 610A is identified. Here, the example system may find a data flow having the longest data flow sequence length in the computation node group A.

### Step 213

The example system may determine a computation node included in the second data flow sequence as a merge target (step 701).

As described above, when the example system performs soft merge on a computation node group in which the length of a data flow sequence is long, there is a technical advantage that it is possible to reduce overhead (overhead of communication between reconfigurable devices, a PR region and a reconfigurable device, or PR regions) associated with input and output between a plurality of computation nodes (which are to be written in different reconfigurable devices or PR regions thereof).

The above processing is an example, and the example system may automatically identify a part or all of the computation node groups to be soft-merged in the computation node groups by various different techniques. An example system may automatically identify a part or all of a computation node group as a soft merge target by using a length of a data flow sequence in the computation node group by various techniques. The example system may automatically identify a part or all of the computation node group to be soft-merged by using the fact that the length of the data flow sequence A in the computation node group is longer than the length of the data flow sequence B in the computation node group by various techniques.

An example system may comprise,
an identifying unit configured to identify, for a computation node group A including a plurality of computation nodes, a first length of an input/output path of a first computation node group in the computation node group A and a second length of an input/output path of a second computation node group in the computation node group A;
a determination unit that determines the first computation node group or the second computation node group as a merge target based on the first length and the second length.

Note that, in the present application, determining a plurality of computation nodes as targets of merge may include determining the plurality of computation nodes as targets of soft resource merge, determining the plurality of computation nodes as targets of soft merge, and/or determining the plurality of computation nodes as targets of hard merge.

One computation node may be a superordinate concept of one or more target HDL programs.

The length of the input/output path of the computation node group may be the largest one among the number of computation nodes on the input/output path without a loop between the computation nodes in the computation node group.

The length of the input/output path of the computation node group may be the longest input/output path without a loop among input/output paths based on input/output analysis (data flow analysis) between computation nodes of the computation node group.

The length of the input/output path of the computation node group may correspond to the maximum number of vertices in a path (passing through each vertex only once at most) of a directed graph in a case where each computation node in the computation node group is associated with a vertex of the directed graph and an input/output relationship between the computation nodes is associated with an edge of the directed graph using graph theory.

In the following example, a description will be given of a computation node group that is a target of hard merge after an example system calculates resource information for some or all of data flow sequences in the computation node group.

In addition, the example system may identify a computation node group to be a soft merge target by using information of a bandwidth between computation nodes in addition to the length of the data flow sequence.

This is because, for example, in a case where the computation nodes 1 and 2 are soft-merged when the bandwidth of the computation nodes 1 and 2 is 1GBPS and in a case where the computation nodes 1 and 2 are soft-merged when the bandwidth of the computation nodes 1 and 2 is 100GBPS, the latter is more advantageous than the former in that the overhead of communication between the computation nodes can be further reduced. In this case, there is an advantage that communication overhead can be reduced from a viewpoint different from the length of the data flow sequence described above.

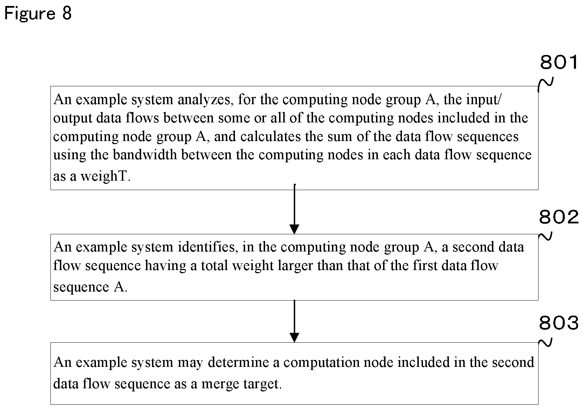

An exemplary processing operation in the example system will be described below with reference to FIG. 8.

### Step 221

For the computing node group A, the input/output data flows between some or all of the computing nodes included in the computing node group A are analyzed, and the sum of the data flow sequences is calculated using the bandwidth between the computing nodes in each data flow sequence as a weight (step 801). The data flow sequence may be the same as that described in step 211.

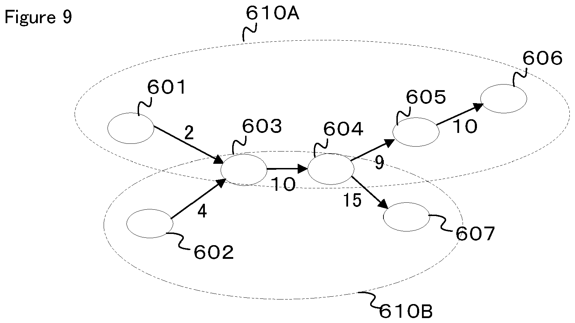

FIG. 9 illustrates computation nodes, data flow sequences based on input/output paths between the computation nodes, and bandwidths between the computation nodes. This figure is different from the previous figure in that bandwidth information is attached to an arrow between computation nodes. These can be shown as a weighted directed graph when the data flow sequences are shown graphically.

### Step 222

In the computing node group A, a second data flow sequence having a total weight larger than that of the first data flow sequence A is identified (step 802).

For example, in this figure, since the total weight 31 of the data flow sequence 610A is larger than the total weight 29 of the data flow sequence 610B, the data flow sequence 610A is identified. Here, the exemplary system may find a data flow having the largest sum of weights of data flow sequences in the computation node group A.

### Step 223

The example system may determine a computation node included in the second data flow sequence as a merge target (step 803).

As described above, when the example system performs soft merge on a computation node group having a large sum of weights of data flow sequences, there is a technical advantage that it is possible to reduce overhead (overhead of communication between reconfigurable devices, a PR region and a reconfigurable device, or PR regions) associated with input and output between a plurality of computation nodes (which are to be written in different reconfigurable devices or PR regions thereof).

An example system may include a selection unit configured to select, from a first computation node group including a plurality of computation nodes including a first computation node and a second computation node, a computation node group including the first computation node and the second computation node, which is a subset of the first computation node group, by using information related to an input/output path between computation nodes in the computation node group.

The information related to the input/output path between the computation nodes in the computation node group may include a length of the input/output path between the computation nodes in the computation node group, information on a weight of the input/output path between the computation nodes in the computation node group, and/or information on a total weight of the input/output path between the computation nodes in the computation node group.

In addition, the following example relates to a technique of selecting a computation node to be soft-merged from the viewpoint of hardware resources. That is, in order for the soft-merged computation node to be written to the hardware resource, the soft-merged computation node needs to be executable in the hardware resource. Here, from the viewpoint of hardware resources, it is preferable to identify the computation node to be soft-merged so as to be within the resource information corresponding to the hardware resource unit.

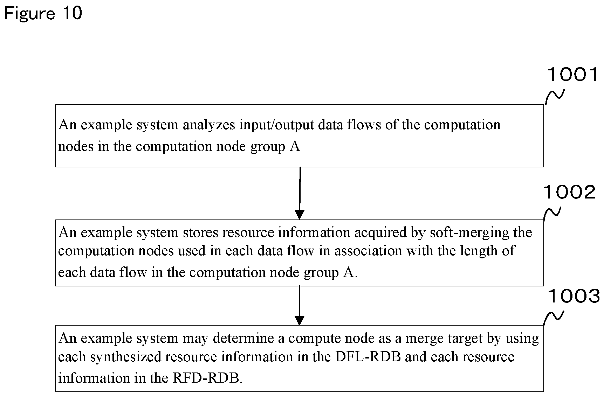

An exemplary processing operation in the example system will be described below with reference to FIG. 10.

### Step 231

An example system analyzes input/output data flows of the computation nodes in the computation node group A (step 1001).

### Step 232

The example system stores resource information acquired by soft-merging the computation nodes used in each data flow in association with the length of each data flow in the computation node group A (step 1002). For example, in a case where one data flow sequence is constituted by computing nodes N1, N2, N3, N4, and N5 in this order, information identifying each data flow sequence such as N1-N2-N3-N4-N5, N1-N2-N3-N4, N2-N3-N4-N5, N1-N2-N3, N3-N4-N5, and N2-N3-N4, the length of the corresponding data flow sequence, and synthesized resource information in a case where software resource merging is performed on the corresponding data flow sequence are stored in association with each other. Note that the length of the corresponding data flow sequence may be omitted. This is because, if there is synthesized resource information, information for identifying necessary hardware resources corresponding to each data flow sequence can be known. Note that a database that stores synthesized resource information corresponding to some or all of the family of set of the data flow sequences in association with the family of sets may be referred to as a data flow sequence resource database (DFL-RDB).

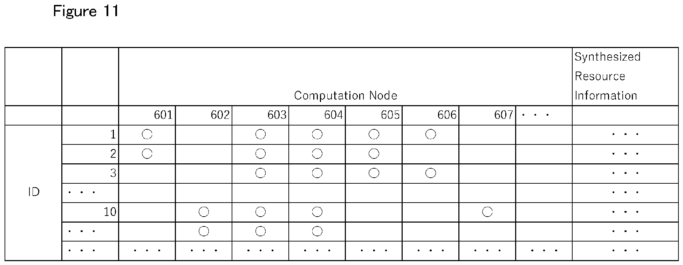

FIG. 11 is an example of a part of the DFL-RDB in FIG. 6 (but is not limited to such a configuration). In this figure, ID1 corresponds to the data flow sequence 610A composed of the computation nodes 601,603 to 606, and ID10 corresponds to the data flow sequence 610B composed of the computation nodes 602,603,604, and 607. The data flow sequences 610A and 610B can also consider other computation node sets in the computation node group (assuming the configuration of the data flow sequence). For example, ID2 is a data flow sequence including the computation nodes 601 and 603 to 605, and ID3 is a data flow sequence including the computation nodes 603 to 606. The synthesized resource information may be stored in the DFL-RDB in association with each of the data flow sequences.

### Step 233

The example system may determine a compute node as a merge target by using each synthesized resource information in the DFL-RDB and each resource information in the RFD-RDB (step 1003).

For example, an example system may identify a computation node related to a data flow sequence for one synthesized resource information among synthesized resource information in the DFL-RDB, which can be executed by resource information for one hardware resource in the RFD-RDB. In this case, there is an advantage that a computation node of a data flow sequence that can be executed by one hardware resource in the RFD-RDB can be identified, and an overhead between input and output data in the computation node in the data flow sequence can be reduced. In this case, the executable resource information may be idnetified by a calculation process of comparing each combination of the resource information of one hardware resource in the RFD-RDB and one synthesized resource information among the synthesized resource information in the DFL-RDB.

In particular, the exemplary system may identify a computation node related to a data flow sequence for one synthesized resource information among synthesized resource information in the DFL-RDB, the computation node being executable by one reconfigurable device among hardware resources in the RFD-RDB. In this case, since the reconfigurable device can be used as the hardware resource, there is an advantage that the hardware resource in the reconfigurable device can be used more efficiently.

Further, the example system may identify a computation node related to a data flow sequence for one synthesized resource information among the synthesized resource information in the DFL-RDB, the computation node being executable by only one PR region in one reconfigurable device among the hardware resources in the RFD-RDB. In this case, since a plurality of PR regions are not set in the configurable device, there is an advantage that the overhead of processing for a plurality of PR regions can be reduced and hardware resources can be used more effectively.

An example of a reconfigurable device may be a device in which a bit stream related to a computation node identified using information related to an input/output path between computation nodes is written. Such a reconfigurable device has an advantage that processing can be performed with reduced overhead between computation nodes.

In an example of a reconfigurable device, a bit stream related to an identified computation node may be written using resource information of the reconfigurable device or resource information of a PR region in the reconfigurable device. Such a reconfigurable device has an advantage that processing can be performed with reduced overhead between computation nodes.

An example reconfigurable device may be one in which a bit stream based on a plurality of computation nodes corresponding to synthesized resource information subjected to soft resource merge is written in a unique PR region in the reconfigurable device. Such a reconfigurable device has an advantage that processing can be performed with reduced overhead between computation nodes.

An example of a reconfigurable device may be a device in which a bit stream based on a plurality of computation nodes identified by using the DFL-RDB is written. Such a reconfigurable device has an advantage that processing can be performed with reduced overhead between computation nodes.

### 4. Third Embodiment

A system of a present example according to the third embodiment is a technique for supporting a change from two or more N computation nodes to M computation nodes (N and M are natural numbers, and M is smaller than N). Some or all of the computing nodes to be soft-merged may be automatically determined.

The system according to the present example provides a method different from that of the second embodiment for selecting a computation node to be soft-merged. In a case where a plurality of computation nodes can be soft-merged and written to one hardware resource, there is a possibility that the overhead between the plurality of computation nodes can be abstractly reduced, but it is not clear to what extent the overhead can be actually reduced. Therefore, the inventor according to the present application presents a technique of selecting a computation node to be synthesized by focusing on information on how much communication traffic is actually generated between a plurality of computation nodes according to the present application.

An example system may include a monitoring unit.

A monitoring unit of an example system may monitor each reconfigurable device based on information from the task manager written in each reconfigurable device.

The task manager written in each reconfigurable device may collect information related to communication of the reconfigurable device in which the task manager is written, and notify the monitoring unit of the information.

The monitoring unit of the example system may acquire, from task managers written in one or more reconfigurable devices, information related to communication of the reconfigurable devices in which the task managers are written. The information related to the communication may set as an operation unit in the reconfigurable device, and the information related to the communication may be associated with information (for example, ID) indicating the operation unit. For example, when there is no PR region in one reconfigurable device, the one reconfigurable device may be one operation unit, the information for identifying the one reconfigurable device and the information related to communication may be associated with each other, and the monitoring unit may acquire the information from the task manager and store the information. Further, for example, when one or more PR regions are included in one reconfigurable device, each of the one or more PR regions may be one operation unit, information identifying the one or more PR regions may be associated with corresponding communication-related information, and the monitoring unit may acquire the information from the task manager and store the information.

The task manager may correspond to, for example, an Element Manager (EM) in Network Functions Virtualization (NFV).

The task manager may continuously or periodically acquire information related to communication in each reconfigurable device.

The information related to communication may include the number of communication bits, the number of times of communication, a communication amount, a communication frequency, a communication ratio, a communication fee, the number of communication bits per predetermined unit, the number of times of communication per predetermined unit, a communication amount per predetermined unit, a communication frequency per predetermined unit, a communication ratio per predetermined unit, a communication fee per predetermined unit, and/or statistical information based on some or all of these (also referred to as "inter-communication information "). In addition, the information related to communication may include communication source information and communication destination information separately for communication in the inter-communication information. The information related to the communication may include inter-communication information, communication source information of the communication in the inter-communication information, and communication destination information of the communication in the inter-communication information in association with each other. The predetermined unit may be a predetermined time unit and/or a predetermined event unit. The statistical information may include information acquired by applying processing such as a total value, a maximum value, a minimum value, a median value, a mode value, a midpoint value, a representative value, various average values, weighting calculation, and/or threshold calculation using each information one or more times as appropriate.

The task manager may transmit the information related to the communication to the monitoring unit at a predetermined timing. The timing of the transmission may be periodic or a timing at which a predetermined condition is satisfied. The predetermined condition may include a case where information related to communication exceeds a predetermined threshold. For example, it may be a case where the number of communication bits, the number of times of communication, the communication amount, the communication frequency, the communication ratio, the communication fee, the number of communication bits per predetermined unit, the number of times of communication per predetermined unit, the communication amount per predetermined unit, the communication frequency per predetermined unit, the communication ratio per predetermined unit, the communication fee per predetermined unit, and/or statistical information based on some or all of these exceeds a predetermined threshold.

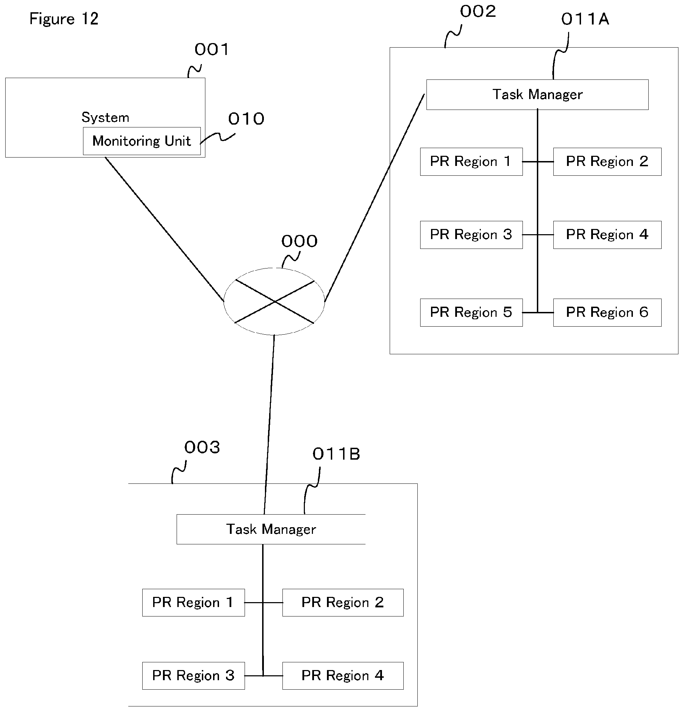

FIG. 12 is an example disclosing a monitoring unit and a task manager stored in one or more reconfigurable devices. In this figure, the monitoring unit 010 in the example system 001 may acquire information related to communication from the task manager 011A in the reconfigurable device 002 and acquire information related to communication from the task manager 011B in the reconfigurable device 003. The task manager 011A may acquire information related to communication regarding the PR regions 1 to 6. The task manager 011B may acquire information related to communication regarding the PR regions 1 to 4.

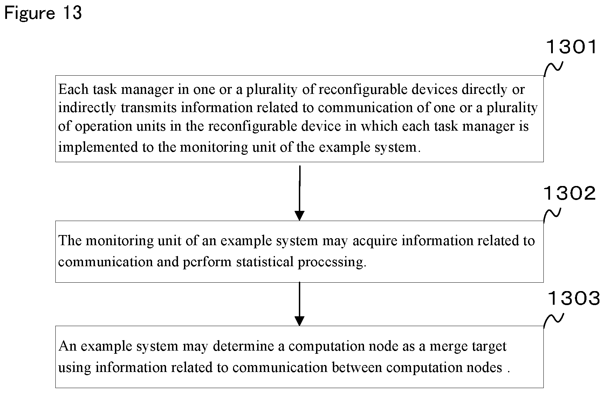

Hereinafter, an example using the monitoring unit of the example system will be described with reference to FIG. 13. First, it is assumed that each computation node in the computation node group A is written in the reconfigurable device and is ready to execute computation. Here, some or all of the computation nodes may not be soft-merged. Some of the computation nodes may be soft-merged. In the latter case, after soft merge is performed on some of the computation nodes, a computation node to be soft-merged may be selected again.

### Step 311

Each task manager in one or a plurality of reconfigurable devices directly or indirectly transmits information related to communication of one or a plurality of operation units in the reconfigurable device in which each task manager is implemented to the monitoring unit of the example system (step 1301).

### Step 312

The monitoring unit of the example system may acquire information related to communication and perform statistical processing. The monitoring unit may generate statistical information using the information related to communication acquired from the task manager (step 1302). The statistical information may include information acquired by applying processing such as a total value, a maximum value, a minimum value, a median value, a mode value, a midpoint value, a representative value, various average values, weighting calculation, and/or threshold calculation using each information one or more times as appropriate.

### Step 313

The example system may determine a computation node as a merge target using information related to communication between computation nodes (step 1303).

For example, in a case where information related to communication between a first computation node and a second computation node is higher than a predetermined threshold, the example system may process the first computation node and the second computation node as computation nodes to be subjected to soft resource merge, process the first computation node and the second computation node as computation nodes to be subjected to soft merge, and/or process the first computation node and the second computation node as computation nodes to be subjected to hard merge.

In addition, in a case where one data flow sequence includes computing nodes N1, N2, N3, N4, and N5 in this order, an example of the system includes a database (such a database may be referred to as a measured information database (MI-DB) in the present application) in which information identifying each data flow sequence such as N1-N2-N3-N4-N5, N1-N2-N3-N4, N2-N3-N4-N5, N1-N2-N3, N3-N4-N5, and N2-N3-N4 and information based on information related to communication between computing nodes along the corresponding data flow sequence are stored in association with each other. Here, the information related to communication between computation nodes along one data flow sequence may be information related to communication corresponding to the one data flow sequence calculated using information related to communication between each two computation nodes along the one data flow sequence. For example, when the one data flow sequence is a data flow sequence in the order of N1, N2, and N3, the total information of the information related to the communication of the one data flow sequence may be the total of the information related to the communication of N1 and N2 and the information related to the communication of N2 and N3. In addition, instead of the total, information acquired by performing statistical processing using information related to communication between N1 and N2 and information related to communication between N2 and N3 may be used.

An example system may comprises:
a monitoring unit for acquiring information related to the communication from one or a plurality of reconfigurable devices; and
a processing unit that performs soft resource merge, soft merge, and/or hard merge for a plurality of computation nodes for the information related to the communication by using the information related to the communication.

The information related to the communication may be, for example, information related to communication between a first PR region in a first reconfigurable device and a second PR region different from the first PR region in the first reconfigurable device. In this case, there is an advantage that information between different PR regions in the same reconfigurable device can be used.

The information related to communication may be, for example, information related to communication between a first PR region in a first reconfigurable device and a second PR region in a second reconfigurable device different from the first reconfigurable device. In this case, there is an advantage that information between different PR regions in different reconfigurable devices can be used.

The information related to the communication may be transmitted by a task manager written in the one or more reconfigurable devices. The task manager may be written in the reconfigurable device, and may have a function of performing communication such as transmission and/or reception with an information processing device outside the reconfigurable device. The task manager may have a function of acquiring information related to communication performed between one or a plurality of PR regions written in the reconfigurable device in which the task manager is written and an information processing device outside the reconfigurable device.

As described above, the example system identifies a target to be soft-merged by using information related to communication, and thus has an advantage that overhead may be reduced in accordance with the actual situation of communication. In particular, if information acquired is used as the communication-related information when the target HDL program is actually written in the reconfigurable device and executed, there is an advantage that the target to be hard-merged can be identified based on the actual information. In addition, the information related to communication may be acquired by simulation, and in this case, there is an advantage that overhead can be reduced within the range of the information acquired by simulation.

An example of the reconfigurable device may be a reconfigurable device in which a bit stream is written based on a plurality of computation nodes identified based on the information related to the communication acquired by the monitoring unit. Such a reconfigurable device has an advantage that processing can be performed with reduced overhead between computation nodes.

An example of the reconfigurable device may be a device in which a bit stream is written based on a plurality of computation nodes identified using the MI-RDB. Such a reconfigurable device has an advantage that processing can be performed with reduced overhead between computation nodes.

### 5, Embodiment 4

The system of a present example according to the fourth embodiment is a technique for supporting a change from two or more N computation nodes to M computation nodes (N and M are natural numbers, and M is smaller than N). Some or all of the computing nodes to be soft-merged may be automatically determined.

An example system may include some or all of the functions of the system according to the second embodiment and some or all of the functions of the system according to the third embodiment.

For example, a part or all of the DFL-RDB in the system according to the second embodiment and a part or all of the MI-DB in the system according to the third embodiment are stored in association with corresponding data flow sequence (such a database may be referred to as a measured information resource database (MI-RDB) in this application document). A part or all of the computation nodes constituting the data flow sequence may be determined as a merge target by using synthesized resource information when the computation nodes constituting the data flow sequence are soft-merged for one data flow sequence and information related to communication between the computation nodes.

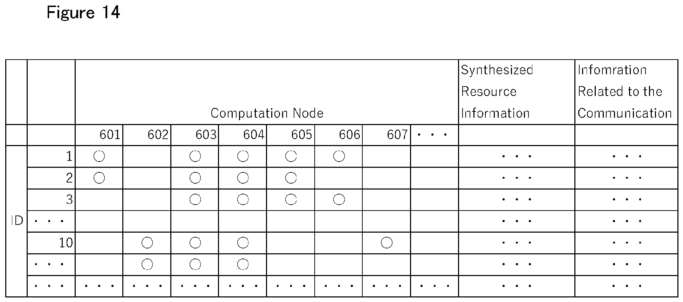

A specific example of the MI-RDB may be a database in which, in a case where one data flow sequence is configured by computing nodes N1, N2, N3, N4, and N5 in this order, information for identifying each data flow sequence such as N1-N2-N3-N4-N5, N1-N2-N3-N4, N2-N3-N4-N5, N1-N2-N3, N3-N4-N5, and N2-N3-N4, synthesized resource information in a case where the computing nodes configuring the corresponding data flow sequence are soft-merged, and information based on information related to communication between the computing nodes along the corresponding data flow sequence are stored in association with each other. For example, FIG. 14 is an example of the MI-RDB.

As an example using the MI-RDB, the system according to an example of the present example may identify one or a plurality of data flow sequences that can be written to one hardware resource based on a comparison between the one hardware resource and the synthesized resource information in the MI-RDB, and may determine a computation node as a merge target using information related to communication of the one or the plurality of data flow sequences.

An example of the reconfigurable device may be a device in which a bit stream is written based on a plurality of computation nodes identified using the MI-RDB. Such a reconfigurable device has an advantage that processing can be performed with reduced overhead between computation nodes.

### 6. Embodiment 5

The system of the present example according to the fifth embodiment is a technique for supporting a change from two or more N computation nodes to M computation nodes (N and M are natural numbers, and M is smaller than N). In addition, the example system is an example including a partially manual part.

An example system may be a technology for providing information related to selection of soft merge to a user.

The background of an example system will be described with reference to FIG. 11. In this figure, a data flow sequence 100A including computation nodes 112A, 113A, and 114A and a data flow sequence 100B including computation nodes 112B, 113B, 114B, and 115B are disclosed. Here, it is assumed that the data flow sequence 100B is not hard-merged even if the data flow sequence 100A is hard-merged. When there is an output from the data flow sequence 100A but there is no output from the data flow sequence 100B, the computation node 116 cannot perform computation processing, and if the computation node 116 waits for the output of the data flow sequence 100B, the possibility that overhead can be reduced may decrease even if only the data flow sequence 100A is hard-merged. In such a case, in a case where the hard merge is performed on the data flow sequence 100A and the hard merge is not performed on the data flow sequence 100B, there is a case where the significance of performing the hard merge on the data flow sequence 100A is low.

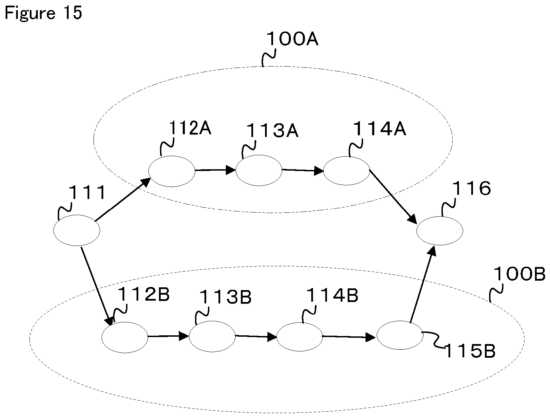

For example, an example system may perform data flow analysis on a computation node group, display a data flow sequence on a display device, and illustrate computation node candidates to be soft-merged. FIG. 15 is an example of a portion of a display screen displayed to a user by an example system. In this case, there is an advantage that a user who views the display device can understand the positioning of the computation nodes to be soft-merged in the entire data flow sequence, and for example, can understand whether or not only the computation nodes of one data flow sequence are soft-merged among the data flow sequences in which parallel computations are performed , and there is a data flow sequence which is not soft-merged in which the parallel computations are performed .

Additionally or alternatively, the example system may display information generated in the soft resource merge on a display device so that the user can understand the information. For example, the example system may display, on the display device, resource information related to a computation node on which software resource merge to be performed and/or synthesized resource information in a case where software resource merge was performed. In this case, there is an advantage that the user can understand the resource information before the soft resource merge is performed and after the soft resource merge is performed.

In addition, the example system may display, on the display device, the resource information related to the computation node on which the soft resource merge to be performed and the synthesized resource information in a case where the soft resource merge was performed in comparison with each other. The information to be compared may be resource information or information corresponding to one attribute of the resource information. In this case, there is an advantage that the user can easily understand the resource information on the corresponding attributes before and after the soft resource merge. For example, in a case where the number of logic blocks is A1 and A2, respectively, as the resource information related to two computation nodes to be subjected to the soft resource merge, and the number of blocks of the synthesized resource information in a case where the soft resource merge was performed is A3, A3 may be displayed on the display device in association with A1 and A2. In addition, for example, in a case where frequencies are B1 and B2 as resource information related to two computation nodes to be subjected to the soft resource merge and a frequency of synthesized resource information in a case where the soft resource merge was performed is B3, B3 may be displayed on the display device in association with B1 and B2. In this case, when the frequency B2 is higher than the frequency B1, and when the one having a lower frequency is used as the synthesized resource information, B3 is the same as B1. Thus, B3 having a lower frequency than B2 may be highlighted on the display device. In this way, when the function of the hardware after the soft resource merge is degraded as compared with that before the soft resource merge, the degraded portion may be highlighted. In this case, there is an advantage that the user can easily understand that the function is degraded by the soft merge.

However, the present invention is not limited to such a case. The synthesized resource information when soft resource merging is performed may include a plurality of different frequencies.

In addition, the example system may display the resource information related to the computation node to be soft-merged or hard-merged and the resource information of the corresponding hardware resource to be written on the display device in comparison with each other. The information to be compared may be resource information or information corresponding to one attribute of the resource information. For example, when the number of internal memories of the resource information related to the computation node to be soft-merged or hard-merged is A1 and the resource information of the corresponding hardware resource to be written is A2, A1 and A2 may be contrasted and displayed on the display device.

In addition, the example system may display, on the display device, resource information related to a computation node to be soft-merged or hard-merged and resource information of one or a plurality of hardware resources as candidates to be written in a contrasting manner. The information to be compared may be resource information or information corresponding to one attribute of the resource information. Further, in such a case, the example system may display, on the display device, information indicating a relationship between resource information related to a computation node to be soft-merged or hard-merged and resource information of one or a plurality of hardware resources as candidates to be written, for example, usage information. For example, when the number of bits of the register of the resource information related to the computation node to be soft-merged or hard-merged is A1, the number of bits of the register in the resource information of one candidate hardware resource to be written is A2, the number of bits of the register in the resource information of another candidate hardware resource to be written is A3, and the number of bits of the register in the resource information of another candidate hardware resource to be written is A4, the usage information based on A1 and A2, the usage information based on A1 and A3, and/or the usage information based on A1 and A4 may be displayed on the display device. In this case, there is an advantage that the user can understand the relationship when the plurality of hardware resource candidates are written.

An example system may display, on a display device, a part or all of information about a process of determining a merge target.

An example system may display information generated in the soft resource merge on a display device.

### 7. Embodiment 6

The system of this example defines the timing of soft resource merge, soft merge, and/or hard merge.

The example system may be implemented together with any one of Embodiments 1 to 5 described above, or may be implemented alone without implementing Embodiments 1 to 5 described above.

The exemplary system may include the monitoring unit described in the third embodiment. In this case, the monitoring unit may acquire information related to communication related to one or more reconfigurable devices.

### Step 611

An example system determines whether a predetermined condition is satisfied.

### Step 612

An example system performs soft resource merge for a plurality of computation nodes that satisfy a predetermined condition.

### Step 621

An example system determines whether a predetermined condition is satisfied.

### Step 622

An example system performs soft merge for a plurality of computation nodes satisfying a predetermined condition.

### Step 631

An example system determines whether a predetermined condition is satisfied.

### Step 632

An example system performs hard merge for a plurality of computation nodes satisfying a predetermined condition.

The predetermined condition may be a condition using the above-described information related to communication. For example, the predetermined condition may be that the information related to the communication exceeds a predetermined corresponding threshold.

Further, the predetermined condition may be a condition using a usage fee for the reconfigurable device based on information related to communication. For example, in a case where the example system has a function of calculating a usage fee based on information related to communication of the reconfigurable device, the predetermined condition may be satisfied when the usage fee exceeds a predetermined threshold.

An example system comprises:
a monitoring unit for acquiring information related to the communication from one or a plurality of reconfigurable devices;
a determination unit that determines whether the information related to the communication satisfies a predetermined condition or does not satisfy the predetermined condition; and
a processing unit that performs soft resource merge, soft merge, and/or hard merge on a plurality of computation nodes for the information related to the communication in accordance with a result of the determination.

The information related to communication for which satisfaction of the predetermined condition is determined may be, for example, information related to communication between a first PR region in a first reconfigurable device and a second PR region different from the first PR region in the first reconfigurable device. In this case, there is an advantage that information between different PR regions in the same reconfigurable device can be used.

The information related to communication for which satisfaction of the predetermined condition is determined may be, for example, information related to communication between a first PR region in a first reconfigurable device and a second PR region in a second reconfigurable device different from the first reconfigurable device. In this case, there is an advantage that information between different PR regions in different reconfigurable devices can be used.

The information related to the communication may be transmitted by a task manager written in the one or more reconfigurable devices. The task manager may be written in the reconfigurable device, and may have a function of performing communication such as transmission and/or reception with an information processing device outside the reconfigurable device. The task manager may have a function of acquiring information related to communication performed between one or a plurality of PR regions written in the reconfigurable device in which the task manager is written and an information processing device outside the reconfigurable device.

For example, in a case where information related to communication between a first computation node and a second computation node is higher than a predetermined threshold, an example system may process the first computation node and the second computation node as computation nodes to be subjected to soft resource merge, process the first computation node and the second computation node as computation nodes to be subjected to soft merge, and/or process the first computation node and the second computation node as computation nodes to be subjected to hard merge.

### 8. Embodiment 7

The system according to the seventh embodiment is different from those according to the first to sixth embodiments, and efficiently performs processing by a reconfigurable device.

The system of the present example may be a system including one or more reconfigurable devices and one or more programmable devices, wherein a part or all of the one or more reconfigurable devices and the one or more programmable devices are capable of communicating information.

Some specific examples of such a system will be described below.

### Embodiment 7-1

A system according to an example includes one or more reconfigurable devices and one or more programmable devices, wherein a part or all of the one or more reconfigurable devices and the one or more programmable devices are capable of communicating information, wherein,
said one or more reconfigurable devices
in the processing of the packet acquired from the outside of said one or plurality of reconfigurable devices, process of determining whether or not a transmission source of said packet is a predetermined transmission source and/or whether or not a transmission destination of said packet is a predetermined transmission destination is performed; and
transmit the packet to the one or more program-variable devices when the transmission source of the packet is a predetermined transmission source and/or when the transmission destination of the packet is a predetermined transmission destination, and does not transmit the packet to the one or more program-variable devices when the transmission source of the packet is not the predetermined transmission source and/or when the transmission destination of the packet is not the predetermined transmission destination; and
the one or more programmable devices perform pattern matching processing in the packet.

The communication of information may be communication via a network. When the packet is not transmitted to the one or more programmable devices, the packet may be transmitted to a third destination or may be discarded. An example of a function that can be realized by such a configuration may be a firewall.

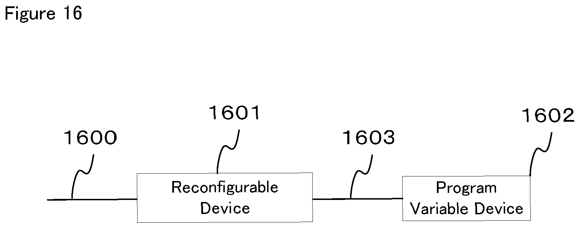

For example, as shown in FIG. 16, a reconfigurable device 1601 may acquire a packet from the outside of the reconfigurable device through a communication circuit 1600, the reconfigurable device 1601 may perform determination processing, and when the transmission source of the packet is a predetermined transmission source and/or the transmission destination of the packet is a predetermined transmission destination, the reconfigurable device 1601 may transmit the packet to the one or more programmable devices 1602 through a communication line 1603, and the programmable device 1602 may perform pattern matching processing. The communication line 1603 may be a general-purpose line or a dedicated line, and may be wireless or wired.

Since the pattern matching processing is not performed by the reconfigurable device for the processing related to the transmission and reception of the packet such as the transmission source and the transmission destination of the packet, there is an advantage that the complicated implementation is not required and the implementation becomes easy while acquiring the benefit of the high speed of the processing by the reconfigurable. In addition, since the processing using the previous packet is realized by the program variable device, there is an advantage that the required roles (the determination of the transmission source and the transmission destination and the processing of the pattern matching) can be appropriately divided in the entire system.

### Embodiment 7-2

A system according to an example includes one or more reconfigurable devices and one or more programmable devices, wherein a part or all of the one or more reconfigurable devices and the one or more programmable devices are capable of communicating information, wherein,
the one or more reconfigurable devices perform processing of a first packet acquired from outside the one or more reconfigurable devices without using a second packet preceding the first packet, and the one or more programmable devices perform processing using a second packet preceding a first packet in processing of the first packet acquired from outside the one or more programmable devices.

The one or more reconfigurable devices may acquire the first packet and the second packet earlier in timing than the one or more programmable devices.

The one or more reconfigurable devices may transmit the first packet and the second packet to the one or more programmable devices.

The one or more reconfigurable devices may acquire the second packet before the first packet.

For example, referring to FIG. 16, the reconfigurable device 1601 may acquire the first and second packets from the outside of the reconfigurable device through the communication circuit 1600, the reconfigurable device 1601 may process the first packet without using the second packet before the first packet and transmit the first and second packets to the one or more programmable devices 1602, and the programmable device 1602 may process the first packet using the second packet before the first packet.

Since the processing that does not use the previous packet is not performed by the reconfigurable device, there is an advantage that complicated implementation (for example, implementation of processing for storing and restoring the previous packet) is not necessary and the implementation becomes easy while acquiring the benefit of the high speed processing by the reconfigurable. In addition, since the processing that uses the previous packet is realized by the program variable device, there is an advantage that the requested (processing that uses the previous packet and processing that does not use the previous packet) can be appropriately divided in the entire system.

### Embodiment 7-3

A system according to an example includes one or more reconfigurable devices and one or more programmable devices, wherein a part or all of the one or more reconfigurable devices and the one or more programmable devices are capable of communicating information, wherein,
said one or plurality of reconfigurable devices perform processing in which a position and/or a range to be referred to in said packet has been determined in determination processing of a packet acquired from outside said one or plurality of reconfigurable devices, and
the one or more program-variable devices perform processing of a packet acquired from outside the one or more program-variable devices, in which a position and/or a range to be referred to in the packet has not been determined.

For example, referring to FIG. 16, a reconfigurable device 1601 may acquire a packet from the outside of the reconfigurable device through a communication circuit 1600, the reconfigurable device 1601 may perform processing in which a position and/or a range to be referred to in the packet has been determined, the reconfigurable device 1601 may transmit the first and second packets to the one or more programmable devices 1602, and the programmable device 1602 may perform processing in which a position and/or a range to be referred to in the packet has not been determined.

Since reconfigurable devices do not perform the processing in which the position and/or range to be referred to in the packet is not determined, there is an advantage that complicated implementation (for example, implementation of processing corresponding to a change in a case where the position to be referred to in the packet is dynamically changed) is not necessary, and the implementation is facilitated while acquiring the benefit of the high speed processing by the reconfigurable. In addition, since the processing using the previous packet is realized by the program variable device, there is an advantage that the required processing can be appropriately assigned to the entire system.

### Embodiment 7-4

A system according to an example includes one or more reconfigurable devices and one or more programmable devices, wherein a part or all of the one or more reconfigurable devices and the one or more programmable devices are capable of communicating information, wherein,
said at least one reconfigurable device processes a packet acquired from outside said at least one reconfigurable device wherein the process is the one by a combination of a predetermined number of predetermined operations, and
the one or more program-variable devices processes a packet acquired from outside the one or more program-variable devices, wherein the process is based on an operation other than a predetermined operation or based on an operation by a combination of predetermined operations more than a predetermined number.

For example, referring to FIG. 16, a reconfigurable device 1601 may acquire a packet from the outside of the reconfigurable device through a communication circuit 1600, the reconfigurable device 1601 may perform processing on the packet by a combination within a predetermined number of predetermined operations and transmit the first and second packets to the one or more programmable devices 1602, and the programmable device 1602 may perform processing on the packet by an operation outside the predetermined number or by a combination of predetermined operations more than a predetermined number.

Since reconfigurable devices do not perform the processing by an operation outside the predetermined number or by a combination of predetermined operations more than a predetermined number, there is an advantage that complicated implementation (for example, implementation of regular expression matching) is not required, and the implementation is facilitated while acquiring the benefit of the high speed of the processing by the reconfigurable device. In addition, there is an advantage that the processing by the combination of the non-predetermined operation or the predetermined operation exceeding the predetermined number is realized by the program variable device, so that the required processing can be appropriately divided in the entire system.

### 9. Various Embodiments

A system according to a first aspect comprises of
an acquisition unit to acquire
   a first resource information that is information about hardware resources that can be used when one or more bit streams related to the first computation node are written to the reconfigurable device; and
   a second resource information that is information about hardware resources that can be used when one or more bitstreams related to the second computation node are written to the
reconfigurable device; and
a generation unit to generate synthesized resource information that is information about hardware resources that can be used when one or more bit streams based on the first computation node and the second computation node are written to the reconfigurable device, using the first resource information and the second resource information.

A system according to a second aspect is in the first aspect,
said first resource information includes a first number of logic blocks, and
said second resource information includes a second number of logic blocks, and
wherein the generation unit calculates a total number of logic blocks of the first number of logic blocks and the second number of logic blocks, and generates the synthesized resource information including the total number of logic blocks.

A system according to a third aspect in the first or the second aspect, wherein
the first resource information includes a first frequency information, and
the second resource information includes a second frequency information, and
the generation unit generates the synthesized resource information including a smaller frequency or both frequencies of the first frequency information and the second frequency information.

A system according to a fourth aspect is in any one of the first to third aspects, wherein
the generation unit generates the synthesized resource information based on an input/output relationship between the first computation node and the second computation node.

A system according to a fifth aspect is in any one of the first to fourth aspects, wherein
an identification unit that identifies one hardware resource capable of executing a computation node corresponding to the synthesized resource information.

A system according to a sixth aspect is in any one of the first to fifth aspects, wherein
the identification unit includes a determination unit
that compares at least one attribute in the synthesized resource information with an attribute corresponding to the at least one attribute in the resource information related to the one hardware resource, and
determines that the latter is capable of executing the former.

A system according to a seventh aspect is in any one of the first to fifth aspects, wherein the identification unit identifies the one hardware resource using an usage information based on the at least one attribute in the synthesized resource information with an attribute corresponding to the at least one attribute in the resource information related to the one hardware resource.

A system according to an eighth aspect is in any one of the first to fifth aspects, further comprising of;
a selection unit that selects a computation node group from a first computation node group, using information related to input/output paths between at least some computation nodes in the first computation node group,
wherein the computation node group includes the first computation node and the second computation node and is a subset of the first computation node group,
wherein the first computation node group comprises of the plural computation node including the first computation node and the second computation node.

A system according to a ninth aspect is in any one of the first to fifth aspects, further comprising of;
a selection unit that selects a computation node group from a first computation node group, using a resource information of a reconfigurable device or a resource information of a PR region in the reconfigurable device;
wherein the computation node group includes the first computation node and the second computation node and is a subset of the first computation node group,
wherein the first computation node group comprises of the plural computation node including the first computation node and the second computation node.

A program to operate one or more information processing device comprising with
means for acquiring
   a first resource information that is information about hardware resources that can be used when one or more bit streams related to the first computation node are written to the reconfigurable device; and
   a second resource information that is information about hardware resources that can be used when one or more bitstreams related to the second computation node are written to the reconfigurable device; and
means for generating synthesized resource information that is information about hardware resources that can be used when one or more bit streams based on the first computation node and the second computation node are written to the reconfigurable device, using the first resource information and the second resource information.

A program according to an eleventh aspect is the program according to the tenth aspect, wherein
the information processing device includes a memory for storing the first resource information and/or the second resource information.

A program according to a twelfth aspect is the program according to the tenth or eleventh aspect, wherein,
the information processing device includes an arithmetic device that performs the generation process.

A method according to a thirteenth aspect is a method to operate one or more information processing device comprising with
a step for acquiring
   a first resource information that is information about hardware resources that can be used when one or more bit streams related to the first computation node are written to the reconfigurable device; and
   a second resource information that is information about hardware resources that can be used when one or more bitstreams related to the second computation node are written to the reconfigurable device; and
a step for generating synthesized resource information that is information about hardware resources that can be used when one or more bit streams based on the first computation node and the second computation node are written to the reconfigurable device, using the first resource information and the second resource information.

A method according to a fourteenth aspect is in the thirteenth aspect, wherein
the information processing device includes a memory for storing the first resource information and/or the second resource information.

A method according to a fifteenth aspect is in the thirteenth or fourteenth aspect, wherein
the information processing device includes an arithmetic device that performs the generation process.

### 10. Configuration Example of a programmable device.

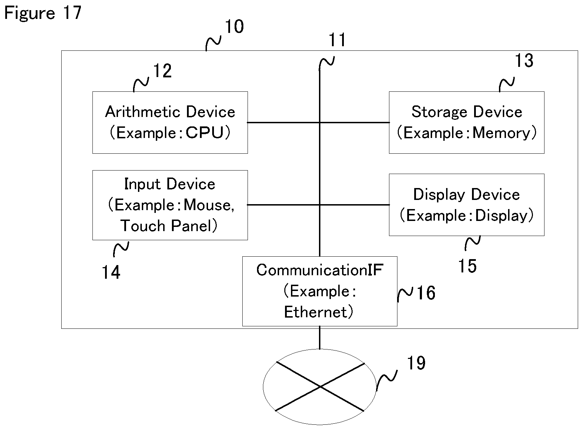

As illustrated in FIG. 17, the program variable device 10 may include an arithmetic device 12, a storage device 13, a communication IF 16, and a bus 11 connecting these components. The programmable device 10 may further include an input device 14, a display device 15, and a bus 11 connecting these devices. The program variable device 10 may be directly or indirectly connected to another information processing device via the network 19.

The program variable device 10 may be an information processing device such as a server or a cloud. It may be a dedicated device or a general-purpose device. The programmable device 10 itself may be a reconfigurable device in which a circuit is written. In this case, there is an advantage that the execution of the programs of the various embodiments described above can be executed more quickly.

In the above description, the configuration executed by the example system has been described, but the configuration may be executed by one or a plurality of information processing devices in the system. The system according to the present application may present information in various manners. For example, presenting information may include displaying information. For example, in the example system, a display device included in the example system may perform display, or a display device in another information processing device to which the example system is directly or indirectly connected may perform display.

It is needless to say that the invention examples described in the embodiments of the present application not limited to those described in the present application and can be applied to various examples within the scope of the technical idea thereof.

Further, the processes and procedures described in this specification may be implemented not only by those explicitly described in the embodiments but also by software, hardware, or a combination thereof. In addition, the processes and procedures described in the present application may be implemented as a computer program and executed by various computers. These computer programs may be stored in a storage medium. These programs may be stored in a non-transitory or non-temporary storage medium.

## Claims

1. A system comprising of;
an acquisition unit to acquire
a first resource information that is information about hardware resources that can be used when one or more bit streams related to the first computation node are written to the reconfigurable device; and
a second resource information that is information about hardware resources that can be used when one or more bitstreams related to the second computation node are written to the reconfigurable device; and
a generation unit to generate synthesized resource information that is information about hardware resources that can be used when one or more bit streams based on the first computation node and the second computation node are written to the reconfigurable device, using the first resource information and the second resource information.

2. The system according to the claim 1, wherein
said first resource information includes a first number of logic blocks, and
said second resource information includes a second number of logic blocks, and
wherein the generation unit calculates a total number of logic blocks of the first number of logic blocks and the second number of logic blocks, and generates the synthesized resource information including the total number of logic blocks.

3. The system according to the claims 1 or 2, wherein
the first resource information includes a first frequency information, and
the second resource information includes a second frequency information, and
the generation unit generates the synthesized resource information including a smaller frequency or both frequencies of the first frequency information and the second frequency information.

4. The system according to any one of the claims 1 to 3, wherein
the generation unit generates the synthesized resource information based on an input/output relationship between the first computation node and the second computation node.

5. The system according to any one of the claims 1 to 4, further comprising of;
An identification unit that identifies one hardware resource capable of executing a computation node corresponding to the synthesized resource information.

6. The system according to the claim 5, wherein
the identification unit includes a determination unit
that compares at least one attribute in the synthesized resource information with an attribute corresponding to the at least one attribute in the resource information related to the one hardware resource, and
determines that the latter is capable of executing the former.

7. The system according to the claim 5, wherein
the identification unit identifies the one hardware resource using an usage information based on the at least one attribute in the synthesized resource information with an attribute corresponding to the at least one attribute in the resource information related to the one hardware resource.

8. The system according to any one of the claims 1 to 7, further comprising of;
a selection unit that selects a computation node group from a first computation node group, using information related to input/output paths between at least some computation nodes in the first computation node group,
wherein the computation node group includes the first computation node and the second computation node and is a subset of the first computation node group,
wherein the first computation node group comprises of the plural computation node including the first computation node and the second computation node.

9. The system according to any one of the claims 1 to 8, further comprising of;
a selection unit that selects a computation node group from a first computation node group, using a resource information of a reconfigurable device or a resource information of a PR region in the reconfigurable device;
wherein the computation node group includes the first computation node and the second computation node and is a subset of the first computation node group,
wherein the first computation node group comprises of the plural computation node including the first computation node and the second computation node.

10. A program to operate one or more information processing device comprising with
means for acquiring
a first resource information that is information about hardware resources that can be used when one or more bit streams related to the first computation node are written to the reconfigurable device; and
a second resource information that is information about hardware resources that can be used when one or more bitstreams related to the second computation node are written to the reconfigurable device; and
means for generating synthesized resource information that is information about hardware resources that can be used when one or more bit streams based on the first computation node and the second computation node are written to the reconfigurable device, using the first resource information and the second resource information.

11. The program according to the claim 10, wherein
the information processing device includes a memory for storing the first resource information and/or the second resource information.

12. The program according to the claims 10 or 11, wherein
the information processing device includes an arithmetic device that performs the generation process.

13. A method to operate one or more information processing device comprising with
a step for acquiring
a first resource information that is information about hardware resources that can be used when one or more bit streams related to the first computation node are written to the reconfigurable device; and
a second resource information that is information about hardware resources that can be used when one or more bitstreams related to the second computation node are written to the reconfigurable device; and
a step for generating synthesized resource information that is information about hardware resources that can be used when one or more bit streams based on the first computation node and the second computation node are written to the reconfigurable device, using the first resource information and the second resource information.

14. The method according to the claim 13, wherein
the information processing device includes a memory for storing the first resource information and/or the second resource information.

15. The method according to the claims 13 or 14, wherein
the information processing device includes an arithmetic device that performs the generation process.
